# EUROPEAN PATENT APPLICATION

(11) **EP 4 746 672 A2**
(43) Date of publication of application: **20.05.2026**
(21) Application number: 25212986.1
(22) Date of filing: 03.11.2025
(51) Int. Cl.: H10P 74/00, H10W 90/20

(54) **CHIP STACK PACKAGE**

(30) Priority: 18.11.2024 KR 20240163963; 27.08.2025 KR 20250119835
(71) Applicant: SK hynix Inc., Bubal-eub Icheon-si Gyeonggi-do 17336 (KR)
(72) Inventor: JANG, Min Ju, Icheon-si, Gyeonggi-do (KR); PARK, Wan Choon, Icheon-si, Gyeonggi-do (KR); LIM, Jung Hwa, Icheon-si, Gyeonggi-do (KR)
(74) Representative: Isarpatent

(57) **Abstract**

A chip stack package includes a first semiconductor chip having a first test bump on a first surface and a second semiconductor chip stacked on a second surface of the first semiconductor chip opposite the first surface. The chip stack package also includes a second test bump bonded to the first test bump. The chip stack package further includes a mold member surrounding the first semiconductor chip, the second semiconductor chip, and the second test bump. The chip stack package additionally includes a test pad disposed on the mold member and connected to the second test bump.

## Description

### TECHNICAL FIELD

Embodiments of the present disclosure relate to a chip stack package.

### BACKGROUND

A chip stack package or a chip stacking package may be a semiconductor package that expands functions and increases capacity and integration by stacking multiple semiconductor chips. A Through-Silicon-Via (TSV) stack package is a chip stack package in which a Through-Silicon-Via (TSV) is formed on a semiconductor chip. The semiconductor chips are electrically connected to each other using the TSV.

In a TSV stack package, a bump or hybrid bonding may be used for connection between chips.

A TSV stack package may include a base chip, a plurality of core chips stacked on the base chip, and a mold member sealing the base chip and the core chips.

### SUMMARY

In accordance with an embodiment of the disclosure is a chip stack package includes: a first semiconductor chip having a first test bump on a first surface; a second semiconductor chip stacked on a second surface of the first semiconductor chip opposite the first surface; a second test bump bonded to the first test bump; a mold member surrounding the first semiconductor chip, the second semiconductor chip, and the second test bump; and a test pad disposed on the mold member and connected to the second test bump.

In accordance with an embodiment of the disclosure is a chip stack package includes: a first semiconductor chip having a test bump on a first surface; a second semiconductor chip stacked on a second surface of the first semiconductor chip opposite the first surface; a mold member surrounding the first semiconductor chip and the second semiconductor chip; and a test pad disposed below the mold member and connected to the test bump.

In accordance with an embodiment of the disclosure is a chip stack package includes: a first semiconductor chip having a first test bump on a first surface; a second semiconductor chip stacked on a second surface of the first semiconductor chip opposite the first surface; a second test bump bonded to the first test bump; a mold member surrounding the first semiconductor chip, the second semiconductor chip, and the second test bump; a redistribution layer disposed on the mold member and the second test bump; and a test pad disposed on the redistribution layer.

In accordance with an embodiment of the disclosure is a chip stack package includes: a redistribution substrate; a first semiconductor chip having a test bump bonded to a first surface of the redistribution substrate; a second semiconductor chip stacked on the first semiconductor chip; a mold member surrounding the first semiconductor chip and the second semiconductor chip; and a test pad disposed on a second surface of the redistribution substrate opposite the first surface.

### BRIEF DESCRIPTION OF THE DRAWINGS

FIG. 1 is a cross-sectional view of a chip stack package according to an embodiment of the present disclosure.
FIG. 2 is an enlarged view of section A of FIG. 1.
FIG. 3 and FIG. 4 are cross-sectional views illustrating a first front bump, a carrier bump, an external connection bump, and a passivation layer of a chip stack package according to embodiments of the present disclosure.
FIG. 5 is a plan view illustrating a chip stack package according to embodiments of the present disclosure.
FIG. 6A and FIG. 6B are drawings for explaining a second alignment bump according to embodiments of the present disclosure.
FIGs. 7, 8, and 9 are cross-sectional views illustrating chip stack packages according to embodiments of the present disclosure in process order.
FIG. 10 is a cross-sectional view of a chip stack package according to an embodiment of the present disclosure.
FIG. 11 is an enlarged view of section B of FIG. 10.
FIG. 12 and FIG. 13 are cross-sectional views illustrating a first front bump, a carrier bump, an external connection bump, and a passivation layer of a chip stack package according to an embodiment of the present disclosure.
FIG. 14 is a cross-sectional view of a chip stack package according to an embodiment of the present disclosure.
FIG. 15 is an enlarged view of section C of FIG. 14.
FIG. 16 is a cross-sectional view illustrating a first front bump, an external connection bump, and a passivation layer of a chip stack package according to an embodiment of the present disclosure.
FIG. 17 is a cross-sectional view of a chip stack package according to an embodiment of the present disclosure.
FIG. 18 is an enlarged view of section D of FIG. 17.
FIG. 19 is a plan view illustrating a first chip pad, a second chip pad, a first front bump, a first test bump, an external connection bump, and a test pad of FIG. 18.
FIG. 20 and FIG. 21 illustrate the first front bump, a carrier bump, and the first test bump, the second test bump of a chip stack package according to embodiments of the present disclosure.
FIG. 22 is a cross-sectional view of a chip stack package according to an embodiment of the present disclosure.
FIG. 23 is an enlarged view of section E of FIG. 22.
FIG. 24 is a cross-sectional view of a chip stack package according to an embodiment of the present disclosure.
FIG. 25 is an enlarged view of section F of FIG. 23.
FIG. 26 is a cross-sectional view of a chip stack package according to an embodiment of the present disclosure.
FIG. 27 is an enlarged view of section G of FIG. 26.
FIG. 28 is a plan view illustrating external connection bumps and test pads of a chip stack package according to an embodiment of the present disclosure.

### DETAILED DESCRIPTION

Embodiments of the present disclosure are described detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

The cross-hatching throughout the figures illustrates corresponding or similar areas between the figures rather than indicating the materials associated with the areas.

When one element is identified as "connected" or "coupled" to another element, the elements may be connected or coupled directly or through an intervening element between the elements. When two elements are identified as "directly connected" or "directly coupled," one element is directly connected or directly coupled to the other element without an intervening element between the two elements.

When one element is identified as "on," "over," or "under" another element, the elements may directly contact each other or an intervening element may be disposed between the elements.

Terms such as "vertically," "top," "bottom," "above," "below," "under," "on," "side," "upper," "lower," "front," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.

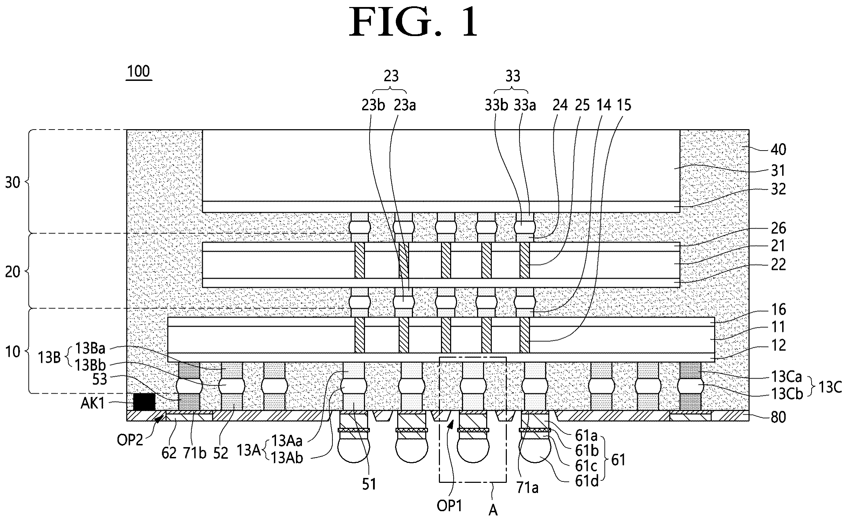

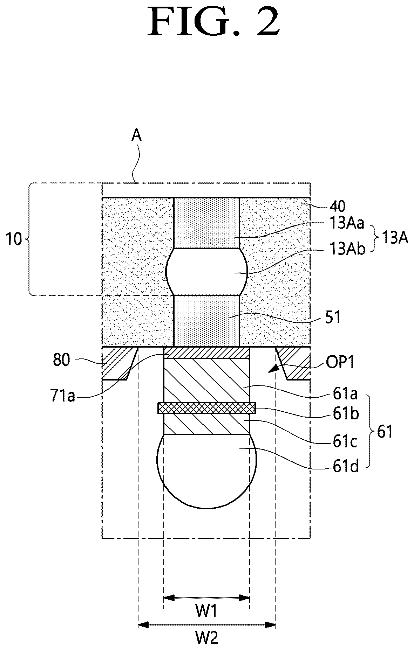

FIG. 1 is a cross-sectional view of a chip stack package according to an embodiment of the present disclosure, and FIG. 2 is an enlarged view of section A of FIG. 1.

Referring to FIG. 1, a chip stack package 100 according to an embodiment of the present disclosure includes a first semiconductor chip 10, a second semiconductor chip 20, a third semiconductor chip 30, a mold member 40, a carrier bump 51, and an external connection bump 61. The chip stack package 100 according to an embodiment of the present disclosure further includes a second dummy bump 52, a second test bump 53, a test pad 62, and a passivation layer 80.

The second semiconductor chip 20 is stacked on the first semiconductor chip 10. The third semiconductor chip 30 is stacked on the second semiconductor chip 20. FIG. 1 illustrates an example in which the number of semiconductor chips to be stacked is three, but the number of semiconductor chips to be stacked in the present disclosure may be two or four or more.

In an embodiment, the first semiconductor chip 10 may be a base die, the second semiconductor chip 20 may be a core middle die, and the third semiconductor chip 30 may be a core top die. Although FIG. 1 includes one core middle die, two or more core middle dies may be stacked between the base die and the core top die.

The first semiconductor chip 10 includes a first substrate 11, a first wiring structure 12, a first front bump 13A, a first back bump 14, and a first through-via 15. In addition, the first semiconductor chip 10 further includes a first dummy bump 13B and a first test bump 13C.

The first substrate 11 includes a first substrate body and a first integrated circuit provided on the first substrate body. The first substrate body may include silicon. The first integrated circuit may be implemented in various ways depending on the type of the first semiconductor chip 10. In an embodiment, the second semiconductor chip 20 and the third semiconductor chip 30 may be memory dies, and the first semiconductor chip 10 may be a logic die for controlling the memory dies. The first integrated circuit may include a logic transistor for controlling the memory dies.

The first wiring structure 12 is disposed on the lower surface of the first substrate 11. Although not shown, the first wiring structure 12 includes wirings and an insulating layer. The lower surface of the first wiring structure 12 may constitute a lower surface of the first semiconductor chip 10. In an embodiment, the lower surface of the first semiconductor chip 10 may face toward the passivation layer 80 and away from the second semiconductor chip 20. The first front bump 13A, the first dummy bump 13B, and the first test bump 13C is disposed on the lower surface of the first semiconductor chip 10.

The first front bump 13A is connected to one of the wirings of the first wiring structure 12. The first front bump 13A is connected to the first integrated circuit through the wiring of the first wiring structure 12. The first front bump 13A may be used for inputting or/and outputting electrical signals, for example, data signals, power supply voltages, and ground voltages.

The first test bump 13C is connected to one of the wirings of the first wiring structure 12. The first test bump 13C is connected to the first integrated circuit through the wiring of the first wiring structure 12. The first test bump 13C is used to test the chip stack package 100. An electrical signal may be applied to the first test bump 13C during a test process. After the test is completed, an electrical signal might not be applied to the first test bump 13C. After the test is completed, the first test bump 13C may be electrically floated.

The first dummy bump 13B may support the first semiconductor chip 10 together with the first front bump 13A and the first test bump 13C, thereby helping to relieve stress applied to the first front bump 13A and the first test bump 13C. In an embodiment, the first dummy bump 13B may fix the first semiconductor chip 10 to a carrier substrate, which will be described later, during the manufacturing process of the chip stack package 100. Thereby, in an embodiment, a warpage in the first semiconductor chip 10 can be suppressed, and solder non-wet problem caused by the warpage can be suppressed. In an embodiment, the first dummy bump 13B may prevent the first semiconductor chip 10 from being pushed down or up due to the pressure of the sealant injected in the process of forming the mold member 40, thereby forming the mold member 40 with a uniform thickness on the lower surface of the first semiconductor chip 10. The first dummy bump 13B might not be used for transmit electrical signal. An electrical signal might not be applied to the first dummy bump 13B. The first dummy bump 13B may be electrically floated.

The first front bump 13A includes a conductive pillar 13Aa under the first wiring structure 12 and a solder layer 13Ab under the conductive pillar 13Aa. In an embodiment, the conductive pillar 13Aa of the first front bump 13A may include nickel (Ni). The conductive pillar 13Aa of the first front bump 13A may be formed of a nickel (Ni) layer. In an embodiment, the conductive pillar 13Aa of the first front bump 13A may be formed of a copper (Cu) layer and a nickel layer under the copper layer. The solder layer 13Ab of the first front bump 13A may include a tin-silver (Sn-Ag) alloy.

An under bump metallurgy (UBM) pattern (not shown) may be disposed between the first wiring structure 12 and the first front bump 13A. The UBM pattern may include a barrier metal layer under the first wiring structure 12 and a seed layer under the barrier metal layer. The barrier metal layer may include titanium (Ti). The barrier metal layer may be a titanium layer. The seed layer may include copper. The seed layer may be a copper layer. The conductive pillar 13Aa of the first front bump 13A may be formed by a plating process using a seed layer.

The first dummy bump 13B includes a conductive pillar 13Ba under the first wiring structure 12 and a solder layer 13Bb under the conductive pillar 13Ba. The first test bump 13C includes a conductive pillar 13Ca under the first wiring structure 12 and a solder layer 13Cb under the conductive pillar 13Ca.

The conductive pillar 13Ba of the first dummy bump 13B and the conductive pillar 13Ca of the first test bump 13C may be formed together with the conductive pillar 13Aa of the first front bump 13A in the process of forming the conductive pillar 13Aa of the first front bump 13A. The conductive pillar 13Ba of the first dummy bump 13B and the conductive pillar 13Ca of the first test bump 13C may be composed of the same material as the conductive pillar 13Aa of the first front bump 13A. In an embodiment, each of the conductive pillar 13Ba of the first dummy bump 13B and the conductive pillar 13Ca of the first test bump 13C may be formed of a nickel layer. In an embodiment, each of the conductive pillar 13Ba of the first dummy bump 13B and the conductive pillar 13Ca of the first test bump 13C may be formed of a copper layer and a nickel layer under the copper layer.

The solder layer 13Bb of the first dummy bump 13B and the solder layer 13Cb of the first test bump 13C may be formed together with the solder layer 13Ab of the first front bump 13A in the process of forming the solder layer 13Ab of the first front bump 13A. The solder layer 13Bb of the first dummy bump 13B and the solder layer 13Cb of the first test bump 13C may be composed of the same material as the solder layer 13Ab of the first front bump 13A. The solder layer 13Bb of the first dummy bump 13B and the solder layer 13Cb of the first test bump 13C may include a Sn-Ag alloy.

A first insulating layer 16 is disposed on an upper surface of the first substrate 11. The first insulating layer 16 may include an inorganic insulating material and/or an organic insulating material. The inorganic insulating material may include silicon nitride, silicon oxide, and silicon oxynitride. The organic insulating material may include polyimide.

The first back bump 14 is disposed over the first through-via 15 and the first insulating layer 16 surrounding the first through-via 15. The first back bump 14 is disposed on the upper surface of the first semiconductor chip 10. In an embodiment, the first back bump 14 may be composed of a copper layer and a nickel layer on the copper layer. In an embodiment, the first back bump 14 may be composed of a nickel layer.

A UBM pattern (not shown) may be disposed between the first back bump 14 and the first through-via 15, and between the first back bump 14 and the first insulating layer 16. The UBM pattern may include a barrier metal layer and a seed layer. The barrier metal layer may be disposed on the first through-via 15 and the first insulating layer 16. The seed layer may be disposed on the barrier metal layer. The first back bump 14 may be formed on the seed layer by a plating process.

The first through-via 15 vertically penetrates the first substrate 11. The first through-via 15 includes a protrusion that protrudes from the upper surface of the first substrate 11. The first insulating layer 16 surrounds the side surface of the protrusion of the first through-via 15. The upper end of the first through-via 15 is connected to the first back bump 14. The lower end of the first through-via 15 is connected to the first wiring structure 12. The first through-via 15 may be connected to the wiring of the first wiring structure 12. The first through-via 15 may be connected to the first front bump 13A through the wiring of the first wiring structure 12.

The second semiconductor chip 20 includes a second substrate 21, a second wiring structure 22, a second front bump 23, a second back bump 24, and a second through-via 25.

The second substrate 21 includes a second substrate body and a second integrated circuit provided on the second substrate body. The second substrate body may include silicon. The second integrated circuit may be implemented in various ways depending on the type of the second semiconductor chip 20. In an embodiment, the second semiconductor chip 20 may be a memory die, and the second integrated circuit may include a memory cell. The memory may include a volatile memory or a nonvolatile memory. The volatile memory may include DRAM (Dynamic Random Access Memory) and SRAM (Static Random Access Memory). The nonvolatile memory may include NAND, NOR, PRAM (Phase Change Random Access Memory), and MRAM (Magneto-Resistive Random Access Memory).

The second wiring structure 22 is disposed on a lower surface of the second substrate 21. Although not shown, the second wiring structure 22 may include wirings and an insulating layer. The lower surface of the second wiring structure 22 may constitute the lower surface of the second semiconductor chip 20.

The second front bump 23 is disposed on the lower surface of the second wiring structure 22. The second front bump 23 is connected to one of the wirings of the second wiring structure 22. The second front bump 23 is connected to the second integrated circuit through the wiring of the second wiring structure 22.

The second front bump 23 includes a conductive pillar 23a under the second wiring structure 22 and a solder layer 23b under the conductive pillar 23a. In an embodiment, the conductive pillar 23a of the second front bump 23 may be formed of a nickel layer. In an embodiment, the conductive pillar 23a of the second front bump 23 may be formed of a copper layer and a nickel layer under the copper layer. The solder layer 23b of the second front bump 23 may include a tin-silver alloy.

A UBM pattern (not shown) may be disposed between the second wiring structure 22 and the second front bump 23. The UBM pattern may include a barrier metal layer under the second wiring structure 22 and a seed layer under the barrier metal layer. The conductive pillar 23a of the second front bump 23 may be formed by a plating process using the seed layer.

A second insulating layer 26 is disposed on the upper surface of the second substrate 21. The second insulating layer 26 may include an inorganic insulating material and an organic insulating material. The inorganic insulating material may include silicon nitride, silicon oxide, and silicon oxynitride. The organic insulating material may include polyimide. The upper surface of the second insulating layer 26 may constitute the upper surface of the second semiconductor chip 20.

The second back bump 24 is disposed over the second through-via 25 and the second insulating layer 26 around the second through-via 25. The second back bump 24 is disposed on the upper surface of the second semiconductor chip 20.

A UBM pattern (not shown) may be disposed between the second back bump 24 and the second through-via 25, and between the second back bump 24 and the second insulating layer 26. The UBM pattern may include a barrier metal layer and a seed layer. The barrier metal layer may be disposed on the second through-via 25 and the second insulating layer 26. The seed layer may be disposed on the barrier metal layer. The second back bump 24 may be formed by a plating process using the seed layer.

In an embodiment, the second back bump 24 may be composed of a copper layer and a nickel layer on the copper layer. In an embodiment, the second back bump 24 may be composed of a nickel layer.

The second through-via 25 vertically penetrates the second substrate 21. The second through-via 25 includes a protrusion protruding beyond the upper surface of the second substrate 21. The second insulating layer 26 surrounds a side surface of the protrusion of the second through-via 25. The upper end of the second through-via 25 is connected to the second back bump 24. The lower end of the second through-via 25 is connected to the second wiring structure 22. The second through-via 25 may be connected to the wiring of the second wiring structure 22, and may be connected to the second front bump 23 through the wiring of the second wiring structure 22.

The second semiconductor chip 20 is connected to the first semiconductor chip 10 through the second front bump 23. The second front bump 23 of the second semiconductor chip 20 is disposed over the first back bump 14 of the first semiconductor chip 10. The second front bump 23 vertically overlaps the first back bump 14. The solder layer 23b of the second front bump 23 is bonded to the first back bump 14.

The third semiconductor chip 30 includes a third substrate 31, a third wiring structure 32, and a third front bump 33.

The third substrate 31 includes a third substrate body and a third integrated circuit provided on the third substrate body. The third substrate body may include silicon. The thickness of the third substrate 31 may be different from the thickness of the second substrate 21. The third substrate 31 may be thicker than the second substrate 21.

The third integrated circuit may be implemented in various ways depending on the type of the third semiconductor chip 30. In an embodiment, the third semiconductor chip 30 may be a memory die, and the third integrated circuit may include a memory cell.

The third wiring structure 32 may be disposed on the lower surface of the third substrate 31. Although not shown, the third wiring structure 32 may include wirings and an insulating layer. The lower surface of the third wiring structure 32 constitutes the lower surface of the third semiconductor chip 30.

The third front bump 33 is disposed on a lower surface of the third wiring structure 32. The third front bump 33 is disposed on the lower surface of the third semiconductor chip 30. The third front bump 33 is connected to one of the wirings of the third wiring structure 32. The third front bump 33 is connected to the third integrated circuit through the wiring of the third wiring structure 32.

The third front bump 33 includes a conductive pillar 33a under the third wiring structure 32 and a solder layer 33b under the conductive pillar 33a.

In an embodiment, the conductive pillar 33a of the third front bump 33 may be formed of a nickel layer. In an embodiment, the conductive pillar 33a of the third front bump 33 may be formed of a copper layer and a nickel layer under the copper layer. The solder layer 33b of the third front bump 33 may include a tin-silver alloy.

A UBM pattern (not shown) may be disposed between the third wiring structure 32 and the third front bump 33. The UBM pattern may include a barrier metal layer under the third wiring structure 32 and a seed layer under the barrier metal layer. The conductive pillar 33a of the third front bump 33 may be formed by a plating process using the seed layer.

The third semiconductor chip 30 is connected to the second semiconductor chip 20 through the third front bump 33. The third front bump 33 of the third semiconductor chip 30 is disposed over the second back bump 24. The third front bump 33 vertically overlaps the second back bump 24. The solder layer 33b of the third front bump 33 is bonded to the second back bump 24.

The first front bump 13A of the first semiconductor chip 10 is bonded to the carrier bump 51. The first front bump 13A of the first semiconductor chip 10 disposed over the carrier bump 51. The first front bump 13A vertically overlaps the carrier bump 51. The solder layer 13Ab of the first front bump 13A is bonded to the carrier bump 51.

The carrier bump 51 includes at least one metal. In an embodiment, the carrier bump 51 may be composed of a copper layer and a nickel layer on the copper layer. In an embodiment, the carrier bump 51 may be composed of a nickel layer.

The first dummy bump 13B of the first semiconductor chip 10 is bonded to the second dummy bump 52. The first dummy bump 13B of the first semiconductor chip 10 is disposed over the second dummy bump 52. The first dummy bump 13B vertically overlaps with the second dummy bump 52. The solder layer 13Bb of the first dummy bump 13B is bonded to the second dummy bump 52.

The first test bump 13C of the first semiconductor chip 10 is bonded to the second test bump 53. The first test bump 13C of the first semiconductor chip 10 is disposed over the second test bump 53. The first test bump 13C vertically overlaps the second test bump 53. The solder layer 13Cb of the first test bump 13C is bonded to the second test bump 53.

The second dummy bump 52 and the second test bump 53 may be formed together with the carrier bump 51 in the process of forming the carrier bump 51. The second dummy bump 52 and the second test bump 53 may be composed of the same material as the carrier bump 51. In an embodiment, the second dummy bump 52 and the second test bump 53 may be formed of a copper layer and a nickel layer under the copper layer. In another embodiment, the second dummy bump 52 and the second test bump 53 may be formed of a nickel layer.

The mold member 40 covers and surrounds the first semiconductor chip 10, the second semiconductor chip 20, the third semiconductor chip 30, the carrier bump 51, the second dummy bump 52, and the second test bump 53. The mold member 40 protects the first semiconductor chip 10, the second semiconductor chip 20, the third semiconductor chip 30, the carrier bump 51, the second dummy bump 52, and the second test bump 53 from the external environment.

The mold member 40 covers the side surfaces of the first semiconductor chip 10, the second semiconductor chip 20, and the third semiconductor chip 30, and the lower surface of the first semiconductor chip 10. The mold member 40 exposes the upper surface of the third semiconductor chip 30. The upper surface of the mold member 40 and the upper surface of the third semiconductor chip 30 may be on the same plane. In an embodiment, because the upper surface of the third semiconductor chip 30 is exposed, heat generated when the first semiconductor chip 10, the second semiconductor chip 20, and the third semiconductor chip 30 operate may be released to the outside of the chip stack package 100 through the upper surface of the third semiconductor chip 30.

The mold member 40 may be extended to fill the spaces between the first semiconductor chip 10, the second semiconductor chip 20, and the third semiconductor chip 30. The mold member 40 may have a molded under-fill (MUF) shape for filling the spaces between the first semiconductor chip 10, the second semiconductor chip 20, and the third semiconductor chip 30. As another example, the spaces between the first semiconductor chip, the second semiconductor chip, and the third semiconductor chip 30 may be filled with an under-fill material different from the mold member 40. As another example, an adhesive layer may be disposed between the first semiconductor chip and the second semiconductor chip and between the second semiconductor chip and the third semiconductor chip, thereby attaching the semiconductor chips to each other.

The mold member 40 may be formed by a molding process using a liquid sealant. The sealant may include an epoxy molding compound (EMC). The epoxy molding compound may include resin and filler.

The lower surface of the carrier bump 51, the lower surface of the second dummy bump 52, and the lower surface of the second test bump 53 is exposed to the lower surface of the mold member 40. The lower surface of the carrier bump 51, the lower surface of the second dummy bump 52, and the lower surface of the second test bump 53 may be disposed on the same plane as the lower surface of the mold member 40. The passivation layer 80 is disposed on the lower surface of the mold member 40. A first opening OP1 is formed in the passivation layer 80 through which the lower surface of the carrier bump 51 is exposed. A second opening OP2 is formed in the passivation layer 80 through which the lower surface of the second test bump 53 is exposed. The passivation layer 80 covers the lower surface of the second dummy bump 52. The passivation layer 80 includes an insulating material. The insulating material may include a polymer-based photosensitive material.

The external connection bump 61 is disposed under the carrier bump 51 exposed through a first opening OP1. The upper section of the external connection bump 61 is disposed inside the first opening OP1.

The first opening OP1 has a greater planar area than that of the carrier bump 51. The external connection bump 61 may have a greater planar area than that of the carrier bump 51. The external connection bump 61 is disposed under the carrier bump 51 and the mold member 40 around the carrier bump 51. The external connection bump 61 vertically overlaps the carrier bump 51 and the mold member 40 around the carrier bump 51.

The external connection bump 61 includes a first copper layer 61a, a first nickel layer 61b under the first copper layer 61a, a second copper layer 61c under the first nickel layer 61b, and a solder layer 61d under the second copper layer 61c.

The thickness of the first copper layer 61a may be greater than the thickness of the first nickel layer 61b. The first copper layer 61a made of copper having a lower resistivity than nickel may be formed thicker than the first nickel layer 61b to secure the electrical conductivity of the external connection bump 61. In an embodiment, the thickness of a layer may be measured in the vertical direction or stacking direction of, for example, the first semiconductor chip 10, the second semiconductor chip 20, and the third semiconductor chip 30.

The first nickel layer 61b is interposed between the first copper layer 61a and the second copper layer 61c. A copper-solder intermetallic compound (not shown) may be formed between the second copper layer 61c and the solder layer 61d. The first nickel layer 61b may suppress diffusion of copper contained in the first copper layer 61a toward the interface between the second copper layer 61c and the solder layer 61d, thereby preventing the formation of a thick copper-solder intermetallic compound. A side surface of the first nickel layer 61b may protrude beyond side surfaces of the first copper layer 61a and the second copper layer 61c. A center section of the first nickel layer 61b may overlap with the first copper layer 61a and second copper layer 61c, and a flange of the first nickel layer 61b may be non-overlapping with the first copper layer 61a and second copper layer 61c.

The second copper layer 61c is interposed between the first nickel layer 61b and the solder layer 61d. Because the nickel-solder intermetallic compound has a higher volume shrinkage rate than the copper-solder intermetallic compound, which makes them more prone to voids and being brittle. Because cracks initiate in the voids and propagate rapidly across the voids, the nickel-solder intermetallic compound is more susceptible to cracking defects than the copper-solder intermetallic compound. According to an embodiment of the present disclosure, because the second copper layer 61c is disposed between the first nickel layer 61b and the solder layer 61d, it is possible to suppress the formation of the nickel-solder intermetallic compound.

The thickness of the second copper layer 61c is less than the thickness of the first copper layer 61a. Because, in an embodiment, the copper included in the first copper layer 61a may be suppressed from diffusing into the interface between the second copper layer 61c and the solder layer 61d by the first nickel layer 61b, and the second copper layer 61c has a less thickness than the first copper layer 61a, the copper-solder intermetallic compound may be formed as a thin film between the second copper layer 61c and the solder layer 61d.

A first UBM pattern 71a is disposed between the external connection bump 61 and the carrier bump 51, and between the external connection bump 61 and the mold member 40. The first UBM pattern 71a includes a barrier metal layer under the carrier bump 51 and the mold member 40, and a seed layer under the barrier metal layer. The barrier metal layer may include titanium. The barrier metal layer may be a titanium layer. The seed layer may include copper. The seed layer may be a copper layer. The first copper layer 61a, the first nickel layer 61b, and the second copper layer 61c of the external connection bump 61 may be formed by a plating process using the seed layer of the first UBM pattern 71a.

The test pad 62 is disposed on the second test bump 53 exposed through the second opening OP2. The test pad 62 may have a greater planar area than that of the second test bump 53. The test pad 62 is disposed below the second test bump 53 and the mold member 40 around the second test bump 53. The test pad 62 vertically overlaps the second test bump 53 and the mold member 40 around the second test bump 53. In an embodiment, the test pad 62 may include copper. The test pad 62 may be a copper layer. In an embodiment, the test pad 62 may include nickel. The test pad 62 may be a nickel layer. In an embodiment, the test pad 62 may include a first copper layer, a nickel layer under the first copper layer, a second copper layer under the nickel layer, and a solder layer under the second copper layer. In an embodiment, the test pad 62 may include a nickel layer and a gold layer under the nickel layer.

A second UBM pattern 71b may be disposed between the test pad 62 and the second test bump 53, and between the test pad 62 and the mold member 40. The second UBM pattern 71b may include a barrier metal layer under the second test bump 53 and the mold member 40, and a seed layer under the barrier metal layer. The barrier metal layer may include titanium. The barrier metal layer may be a titanium layer. The seed layer may include copper. The seed layer may be a copper layer. The test pad 62 may be formed by a plating process using the seed layer of the second UBM pattern 71b.

The chip stack package 100 may further include a first alignment key AK1. The first alignment key AK1 might not overlap with the first semiconductor chip 10. The first alignment key AK1 may be used as a reference point (e.g., zero point) to determine the position of the external connection bump 61 in the process of forming the external connection bump 61. The first alignment key AK1 may be used as a reference point to determine the position of the test pad 62 in the process of forming the test pad 62. The first alignment key AK1 may be used as a reference point to determine the cutting position of the mold member 40 in the process of cutting the mold member 40 to individualize the chip stack package 100.

In an embodiment, the first alignment key AK1 may be formed together with the carrier bump 51 in the process of forming the carrier bump 51. The first alignment key AK1 may be a bump arranged at the same height level as the carrier bump 51. The upper and side surfaces of the first alignment key AK1 may be surrounded with the mold member 40. The lower surface of the first alignment key AK1 may be exposed to the lower surface of the mold member 40. The first alignment key AK1 is not used to input or/and output of a data signal, a power voltage, and a ground voltage. An electrical signal might not be applied to the first alignment key AK1. The first alignment key AK1 may be electrically floated.

Referring to FIG. 2, the first opening OP1 of the passivation layer 80 may have a reverse tapered structure in which the width increases as the distance from the mold member 40 increases. As described above, the passivation layer 80 may be formed of a polymer-based photosensitive material. A photosensitive material layer may be formed on the carrier bump 51 and the mold member 40, and the photosensitive material layer may be partially removed by an exposure process and a development process to form a first opening OP1. After the first opening OP1 is formed, the photosensitive material layer may be hardened by a curing process to form a passivation layer 80. During the curing process, the photosensitive material layer may shrink, and the width of the shrinkage of the photosensitive material layer may increase as the distance from the mold member 40 increases. Accordingly, the width of the first opening OP1 may increase as the distance from the mold member 40 increases, and the first opening OP1 may have a reverse tapered structure in which the width increases as the distance from the mold member 40 increases.

The width of the first copper layer 61a of the external connection bump 61 is W1. The minimum width of the first opening OP1 of the passivation layer 80 is W2. W2 is greater than W1. The planar area of the first opening OP1 may be greater than the planar area of the external connection bump 61. The external connection bump 61 and the passivation layer 80 are disposed to be spaced apart from each other. The passivation layer 80 does not contact the external connection bump 61.

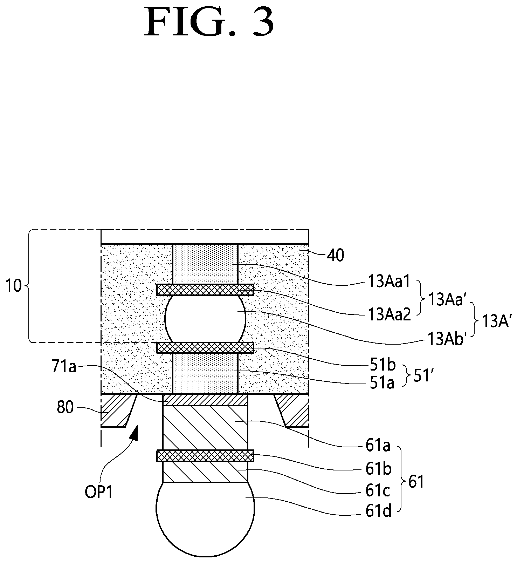

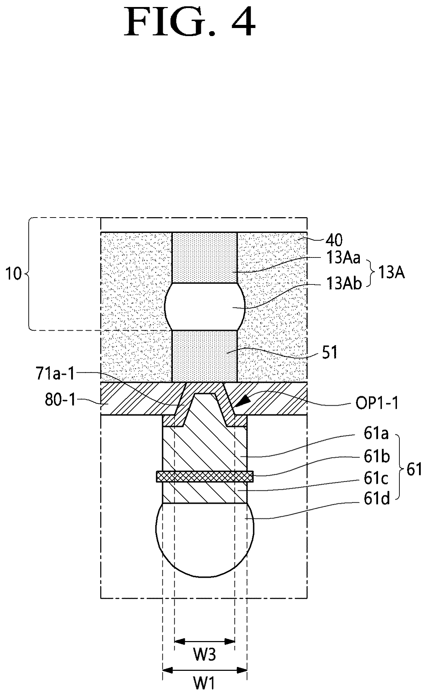

FIG. 3 and FIG. 4 are cross-sectional views illustrating a first front bump, a carrier bump, an external connection bump, and a passivation layer of a chip stack package according to embodiments of the present disclosure.

Referring to FIG. 3, a conductive pillar 13Aa' of a first front bump 13A' includes a copper layer 13Aa1 and a nickel layer 13Aa2 under the copper layer 13Aa1. The nickel layer 13Aa2 covers the lower surface of the copper layer 13Aa1. The nickel layer 13Aa2 is disposed between the copper layer 13Aa1 and the solder layer 13Ab'.

A thickness of the copper layer 13Aa1 is greater than a thickness of the nickel layer 13Aa2. In an embodiment, the electrical conductivity of the first front bump 13A' can be improved, because the copper layer 13Aa1 made of copper having a lower resistivity than nickel is formed thicker than the nickel layer 13Aa2. Although not shown, an copper-solder intermetallic compound may be formed at the interface between conductive pillar 13Aa' and the solder layer 13Ab'. The nickel layer 13Aa2 may suppress the copper included in the copper layer 13Aa1 from diffusing to the interface between the conductive pillar 13Aa' and the solder layer 13Ab'. Thereby, in an embodiment, the formation of a thick copper-solder intermetallic compound can be suppressed.

The side surface of the nickel layer 13Aa2 may protrude more than the side surface of the copper layer 13Aa1 in the horizontal direction. The center of the nickel layer 13Aa2 may vertically overlap with the copper layer 13Aa1, and the flange section of the nickel layer 13Aa2 might not vertically overlap with the copper layer 13Aa1.

A carrier bump 51' includes a copper layer 51a and a nickel layer 51b on the copper layer 51a. The nickel layer 51b covers the upper surface of the copper layer 51a. The nickel layer 51b is disposed between the copper layer 51a and a solder layer 13Ab'. The thickness of the copper layer 51a is greater than the thickness of the nickel layer 51b.

Although not shown, an copper-solder intermetallic compound may be formed at the interface between the carrier bump 51' and the solder layer 13Ab' when bonding between the carrier bump 51' and the solder layer 13Ab'. The nickel layer 51b can suppress the copper included in the copper layer 51a from diffusing to the interface between the carrier bump 51' and the solder layer 13Ab'. Thereby, in an embodiment, the generation of a thick copper-solder intermetallic compound can be suppressed.

Referring to FIG. 4, a first copper layer 61a of an external connection bump 61 has a width of W1. The maximum width of a first opening OP1-1 of a passivation layer 80-1 has a width of W3. W3 is less than W1. The planar area of the first opening OP1-1 of the passivation layer 80-1 may be less than the planar area of the external connection bump 61.

The external connection bump 61 is disposed below the carrier bump 51 exposed by the first opening OP1-1 and the passivation layer 80-1 around the carrier bump 51. The external connection bump 61 vertically overlaps the carrier bump 51 exposed by the first opening OP1-1 and the passivation layer 80-1 around the first opening OP1-1. A first UBM pattern 71a-1 is disposed between the external connection bump 61 and the carrier bump 51, and between the external connection bump 61 and the passivation layer 80-1.

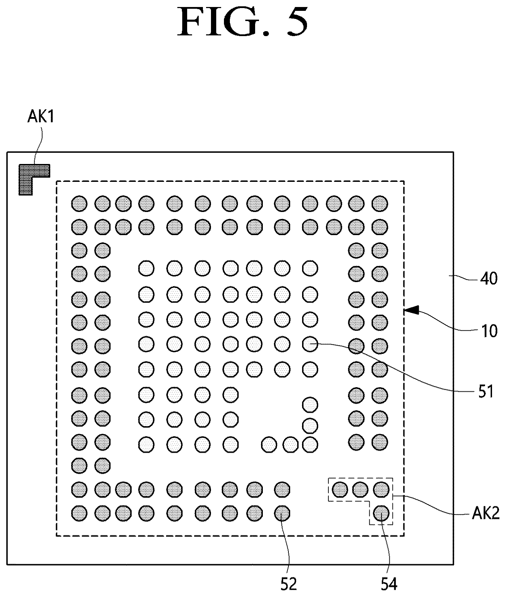

FIG. 5 is a plan view illustrating a chip stack package according to an embodiment of the present disclosure. FIG. 5 is a plan view of the chip stack package viewed from the bottom of the mold member 40.

Referring to FIG. 5, a plurality of bumps 51, 52 and 54 are disposed in an area vertically overlapping with the first semiconductor chip 10. A first alignment key AK1 is disposed on the outside of the area vertically overlapping with the first semiconductor chip 10.

The first alignment key AK1 may have a different plane shape from the bumps 51, 52 and 54. The bumps 51, 52 and 54 may have a circular plane shape, and the first alignment key AK1 may have a planar shape in a shape of a hook or a ' 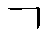 '-shape. FIG. 5 illustrates a case in which the first alignment key AK1 has a planar shape in the shape of a hook, but the planar shape of the first alignment key AK1 may be changed to various shapes such as a square or a triangle.

The bumps include carrier bumps 51, second dummy bumps 52, and second alignment bumps 54. The second alignment bumps 54 constitute a second alignment key AK2. The second alignment bumps 54 have a different arrangement structure from the carrier bumps 51 and the second dummy bumps 52. Accordingly, the semiconductor stack package manufacturing equipment can recognize the second alignment bumps 54 to specify the exact position of the semiconductor chip.

The second alignment key AK2 may play the same role as the first alignment key AK1. FIG. 5 illustrates a case in which both the first alignment key AK1 and the second alignment AK2 are included, but only one of the first alignment key AK1 and the second alignment AK2 may be included.

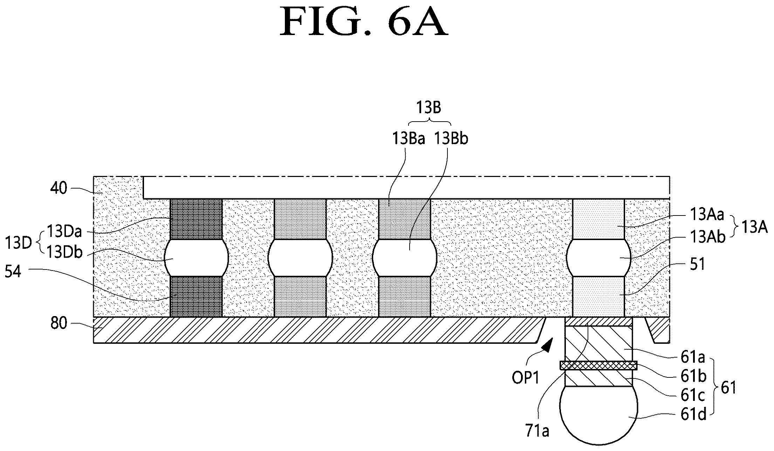

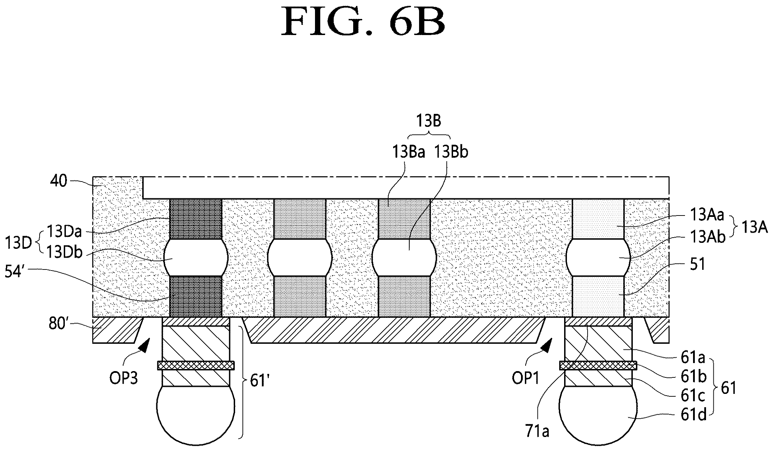

FIG. 6A and FIG. 6B are drawings for explaining a second alignment bump according to embodiments of the present disclosure.

Referring to FIG. 6A, the second alignment bump 54 may be formed together with the carrier bump 51 in the process of forming the carrier bump 51. The second alignment bump 54 may be formed of the same material as the carrier bump 51. The second alignment bump 54 may have the same size as the carrier bump 51.

The first alignment bump 13D is bonded on the second alignment bump 54. The first alignment bump 13D includes a conductive pillar 13Da and a solder layer 13Db.

The conductive pillar 13Da of the first alignment bump 13D may be formed together with a conductive pillar 13Aa of the first front bump 13A in a process of forming the conductive pillar 13Aa of the first front bump 13A. The conductive pillar 13Da of the first alignment bump 13D may be composed of the same material as the conductive pillar 13Aa of the first front bump 13A. The conductive pillar 13Da of the first alignment bump 13D may have the same size as the conductive pillar 13Aa of the first front bump 13A.

The solder layer 13Db of the first alignment bump 13D may be formed together with the solder layer 13Ab of the first front bump 13A in the process of forming the solder layer 13Ab of the first front bump 13A. The solder layer 13Db of the first alignment bump 13D may be formed of the same material as the solder layer 13Ab of the first front bump 13A.

The first alignment bump 13D is disposed over the second alignment bump 54. The first alignment bump 13D vertically overlaps the second alignment bump 54. A solder layer 13Db of the first alignment bump 13D is bonded to the second alignment bump 54. A side surface of the first alignment bump 13D and a side surface of the second alignment bumps 13D and 54 are surrounded with a mold member 40. A lower surface of the second alignment bump 54 may be exposed to the lower surface of the mold member 40.

The lower surface of the second alignment bump 54 is covered with a passivation layer 80. The second alignment bump 54 might not be used for input or/and output of data signals, power voltage, and ground voltage. No electrical signal is applied to the second alignment bump 54. The second alignment bump 54 may be electrically floated.

Referring to FIG. 6B, a third opening OP3 is formed in a passivation layer 80' through which the lower surface of a second alignment bump 54' is exposed. An external connection bump 61' may be connected to the second alignment bump 54 exposed through the third opening OP3. The second alignment bump 54' can transmit one of a data signal, a power voltage, and a ground voltage.

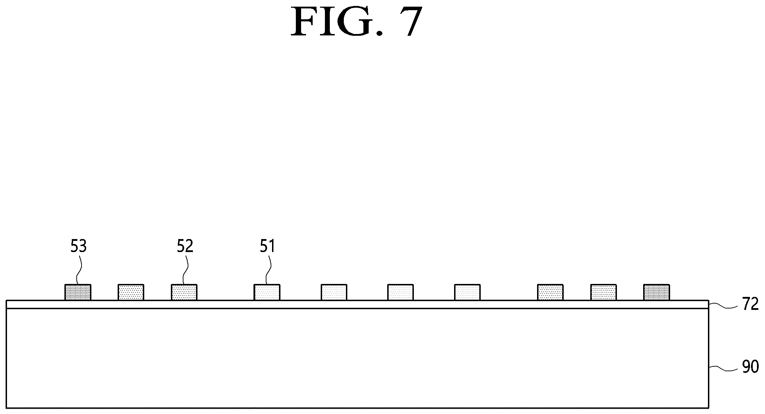

FIG. 7 to FIG. 9 are cross-sectional views illustrating chip stack packages according to embodiments of the present disclosure in process order.

Referring to FIG. 7, a first UBM layer 72 is formed on a first carrier substrate 90, and a carrier bump 51, a second dummy bump 52. A second test bump 53 is formed on the first UBM layer 72. Although not illustrated, an alignment key may be further formed on the first UBM layer 72 during the process of forming the carrier bump 51, the second dummy bump 52, and the second test bump 53.

Although not illustrated, a de-bonding layer may be further formed on the first carrier substrate 90 before forming the first UBM layer 72. In an embodiment, the de-bonding layer may have adhesive characteristics, and may be composed of a material having adhesive strength capable of being reduced by at least one of a chemical treatment and an optical treatment.

The first UBM layer 72 includes a barrier metal layer and a seed layer on the barrier metal layer. The barrier metal layer may include titanium, and the seed layer may include copper. The barrier metal layer and the seed layer may be formed by a deposition method such as sputtering.

The carrier bump 51, the second dummy bump 52, and the second test bump 53 may be formed by forming a first plating resist pattern having opening regions that provide a template for the carrier bump 51, the second dummy bump 52 and the second test bump 53 on the first UBM layer 72, and plating metal into the opening regions of the first plating resist pattern. The first plating resist pattern may be removed after forming the carrier bump 51, the second dummy bump 52, and the second test bump 53.

In an embodiment, each of the carrier bump 51, the second dummy bump 52, and the second test bump 53 may be formed of a nickel layer grown on a seed layer by a plating process. In an embodiment, each of the carrier bump 51, the second dummy bump 52, and the second test bump 53 may be formed of a copper layer grown on a seed layer by a plating process, and a nickel layer grown on a copper layer by a plating process.

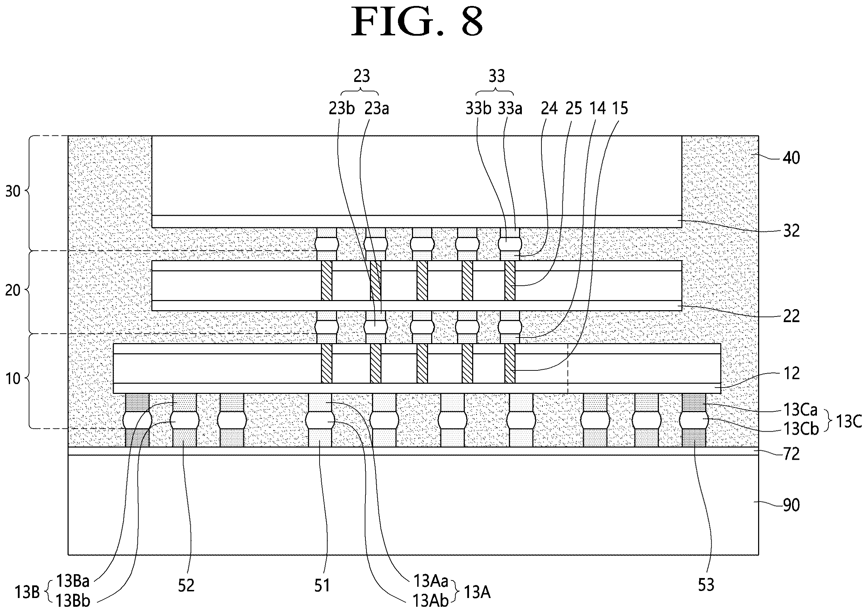

Referring to FIG. 8, the first semiconductor chip 10, the second semiconductor chip 20, and the third semiconductor chip 30 are stacked or stacked on a first carrier substrate 90, and a mold member 40 is formed.

The first semiconductor chip 10 includes a first front bump 13A on a lower surface and a first back bump 14 on an upper surface. The first front bump 13A is connected to the first back bump 14 through a wiring of a first wiring structure 12 and a first through-via 15. The first semiconductor chip 10 further includes a first dummy bump 13B and a first test bump 13C on a lower surface of the first semiconductor chip 10.

The first front bump 13A includes a conductive pillar 13Aa and a solder layer 13Ab under the conductive pillar 13Aa. In an embodiment, the conductive pillar 13Aa of the first front bump 13A may be formed of a nickel layer. In an embodiment, the conductive pillar 13Aa of the first front bump 13A may be formed of a copper layer and a nickel layer under the copper layer. The solder layer 13Ab of the first front bump 13A includes a tin-silver alloy.

The first dummy bump 13B includes a conductive pillar 13Ba and a solder layer 13Bb under the conductive pillar 13Ba. The first test bump 13C includes a conductive pillar 13Ca and a solder layer 13Cb under the conductive pillar 13Ca.

The conductive pillar 13Ba of the first dummy bump 13B and the conductive pillar 13Ca of the first test bump 13C are composed of the same material as the conductive pillar 13Aa of the first front bump 13A. The solder layer 13Bb of the first dummy bump 13B and the solder layer 13Cb of the first test bump 13C are composed of the same material as the solder layer 13Ab of the first front bump 13A.

The first semiconductor chip 10 is bonded on a first carrier substrate 90.

The first semiconductor chip 10 may be disposed on the first carrier substrate 90 such that the first front bump 13A, the first dummy bump 13B, and the first test bump 13C of the first semiconductor chip 10 come into contact with the carrier bump 51, the second dummy bump 52, and the second test bump 53 provided on the first carrier substrate 90, respectively. Then, reflow bonding is performed to bond the first front bump 13A, the first dummy bump 13B, and the first test bump 13C of the first semiconductor chip 10 to the carrier bump 51, the second dummy bump 52, and the second test bump 53, respectively.

The second semiconductor chip 20 includes a second front bump 23 on the lower surface and a second back bump 24 on the upper surface. The second front bump 23 includes a conductive pillar 23a and a solder layer 23b under the conductive pillar 23a. The second front bump 23 is connected to the second back bump 24 through a second through-via 25 and a wiring of a second wiring structure 22.

The second semiconductor chip 20 is stacked on a first semiconductor chip 10. The second semiconductor chip 20 is disposed on the first semiconductor chip 10 such that the second front bump 23 of the second semiconductor chip 20 is in contact with the first back bump 14 of the first semiconductor chip 10.

The third semiconductor chip 30 includes a third front bump 33 on the lower surface. The second front bump 33 includes a conductive pillar 33a and a solder layer 33b under the conductive pillar 33a.

The third semiconductor chip 30 is stacked on the second semiconductor chip 20. The third semiconductor chip 30 is disposed on a second semiconductor chip 20 such that a third front bump 33 of the third semiconductor chip 30 is in contact with a second back bump 24 of the second semiconductor chip 20.

A mass reflow bonding process is performed to bond the second semiconductor chip 20 to the first semiconductor chip 10 and to bond the third semiconductor chip 30 to the second semiconductor chip 20. In an embodiment, the mass reflow bonding process can bond a plurality of semiconductor chips together at once, which is advantageous in increasing productivity.

A preliminary mold member is formed to fill the space between the first carrier substrate 90 and the first semiconductor chip 10 and to cover the first semiconductor chip 10, the second semiconductor chip 20, and the third semiconductor chip 30. Then, in an embodiment, a grinding process is performed for the upper surface of the preliminary mold member to form the mold member 40 to lower the height of the chip stack package to a target value. In the grinding process, the upper surface of the third semiconductor chip 30 may be exposed, and the third semiconductor chip 30 may be ground together with the preliminary mold member, thereby reducing the thickness of the third semiconductor chip 30.

The mold member 40 may be formed in a molded under-fill (MUF) shape that fills the spaces between the first semiconductor chip 10, the second semiconductor chip 20, and the third semiconductor chip 30. Although the spaces between the first semiconductor chip 10, the second semiconductor chip 20, and the third semiconductor chip 30 are filled with the mold member 40 in an embodiment, the spaces between the first semiconductor chip 10, the second semiconductor chip 20, and the third semiconductor chip 30 may be filled with an under-fill member different from the mold member 40 in an embodiment. In an embodiment, the first semiconductor chip 10, the second semiconductor chip 20, and the third semiconductor chip 30 may be attached to each other by a thermal compression bonding method using a non-conductive film, and the non-conductive films may be arranged in the spaces between the first semiconductor chip 10, the second semiconductor chip 20, and the third semiconductor chip 30.

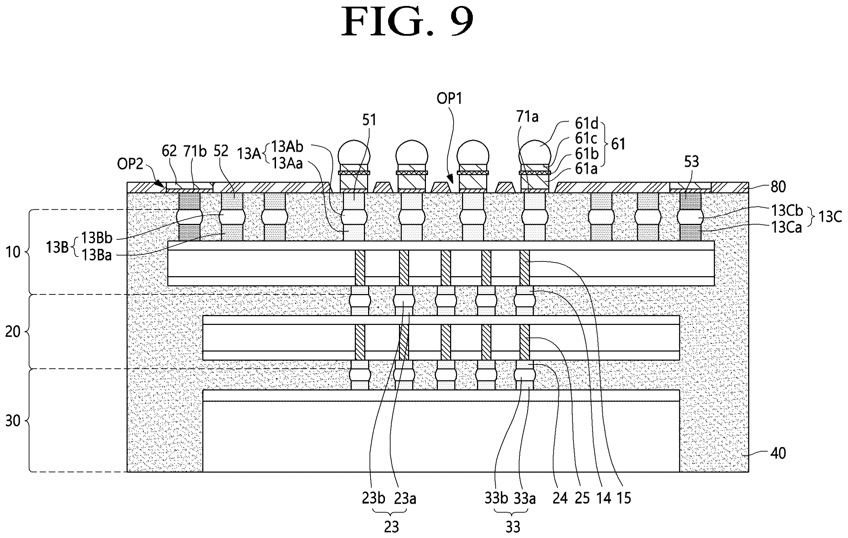

Referring to FIG. 9, the first carrier substrate (90 of FIG. 8) and the first UBM layer (72 of FIG. 8) is removed. In an embodiment, the adhesion of the debonding layer disposed between the first carrier substrate (90 of FIG. 8) and the first UBM layer (72 of FIG. 8) may be reduced by using at least one of a chemical treatment and an optical treatment, and then the first carrier substrate (90 of FIG. 8) may be separated by peeling. In an embodiment, the first carrier substrate (90 of FIG. 8) may be removed by a grinding process. The first UBM layer (72 of FIG. 8) may be removed by an etching process.

Thereafter, a passivation layer 80 is formed the lower surface of the mold member 40 exposed by the removal of the first UBM layer. The passivation layer 80 covers the dummy bump 52. A first opening OP1 is formed in the passivation layer 80 through which the carrier bump 51 is exposed. A second opening OP2 is formed in the passivation layer 80 through which the second test bump 53 is exposed.

In addition, a second UBM layer is formed on the passivation layer 80 and the open areas by the first opening OP1 and the second opening OP2. A second plating resist pattern having an opening area for providing a template for a test pad 62 is formed on the second UBM layer, and a metal is plated in the opening area of the second plating resist pattern to form a test pad 62. The second plating resist pattern may be removed after forming the test pad 62.

A third plating resist pattern having an opening area which provides a template for an external connection bump 61 is formed on the second UBM layer, and metal is plated in the opening area of the third plating resist pattern to form an external connection bump 61. The third plating resist pattern may be removed after forming the external connection bump 61.

The second UBM layer is a pre-structure for forming the first UBM pattern 71a and second UBM pattern 71b. The second UBM layer may include a barrier metal layer and a seed layer on the barrier metal layer. The barrier metal layer may include titanium, and the seed layer may include copper. The barrier metal layer and the seed layer may be formed by a deposition method such as sputtering. The first UBM pattern 71a and the second UBM pattern 71b may be formed by removing the second UBM layer exposed again by the removal of the third plating resist pattern after removing the third plating resist pattern.

Apart from present embodiments, in a comparison example, a first semiconductor chip is temporarily attached to a carrier substrate with an adhesive layer, the first semiconductor chip may move or tilt in the x, y, and z directions due to heat and pressure applied in subsequent processes such as a process of stacking the second semiconductor chip and the third semiconductor chip on the first semiconductor chip and a molding process, which may cause the semiconductor chips to deviate from their designated positions. Thereby, in the comparison example, appearance defects or contact defects can occur. According to the present embodiments, the first semiconductor chip 10 may be fixed to not be moved during the package manufacturing process by bonding the first front bump 13A of the first semiconductor chip 10 to the carrier bump 51 of the carrier substrate 90. Thereby, in an embodiment, defects due to movement of the first semiconductor chip 10 can be prevented or mitigated.

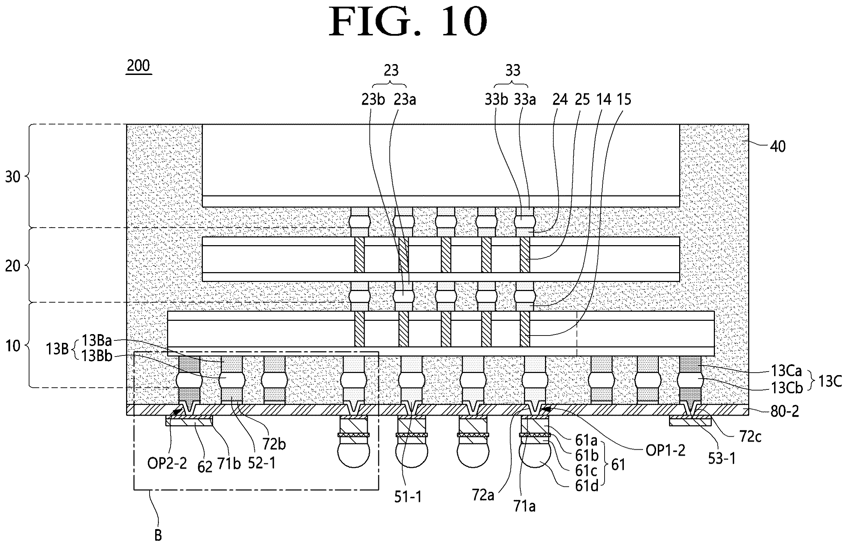

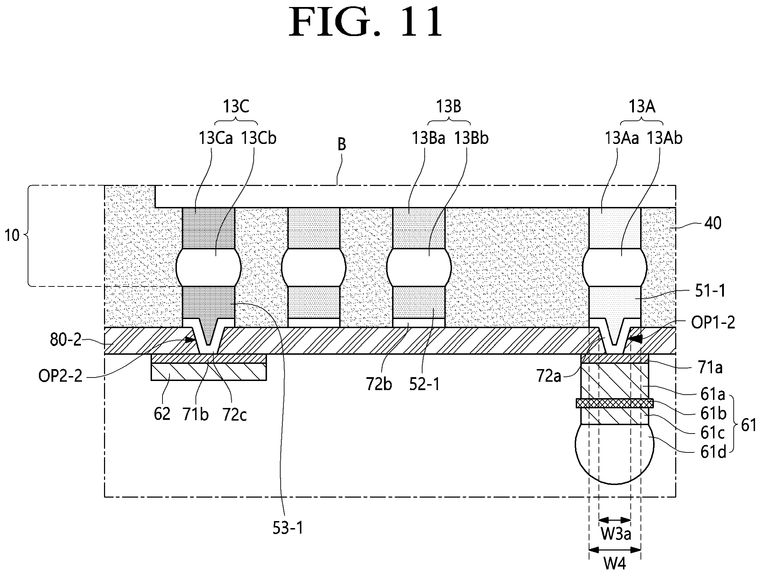

FIG. 10 is a cross-sectional view of a chip stack package according to an embodiment of the present disclosure, FIG. 11 is an enlarged view of section B of FIG. 10, and FIG. 12 and FIG. 13 are cross-sectional views illustrating a first front bump, a carrier bump, an external connection bump, and a passivation layer of a chip stack package according to an embodiment of the present disclosure.

Referring to FIG. 10 and FIG. 11, a passivation layer 80-2 of a chip stacked package 200 includes a first opening OP1-2. The first opening OP1-2 has a tapered shape having a width that decreases as it gets farther away from the first semiconductor chip 10. A second opening OP2-2 of the passivation layer 80-2 has a tapered shape having a width that decreases as it gets farther away from the first semiconductor chip 10.

Before forming the first UBM layer on the carrier substrate, a photosensitive material layer may be formed, and the first opening OP1-2 and the second opening OP2-2 may be formed in the photosensitive material layer through an exposure and development process. After the first opening OP1-2 and the second opening OP2-2 are formed, the photosensitive material layer may be hardened through a curing process to form the passivation layer 80-2. During the curing process, the photosensitive material layer may shrink, and a shrinkage width of the photosensitive material layer may increase as the distance from the carrier substrate increases. Accordingly, the widths of the first opening OP1-2 and the second opening OP2-2 may decrease as the distance from the carrier substrate (i.e., first carrier substrate 90 of FIG. 8) decreases. The first opening OP1-2 and the second opening OP2-2 may have a tapered structure having a width that decreases as the distance from the first semiconductor chip 10 disposed on the passivation layer 80-2 increases.

A carrier bump 51-1 vertically overlaps the first opening OP1-2. The lower end of the carrier bump 51-1 is disposed inside the first opening OP1-2. A second test bump 53-1 vertically overlaps the second opening OP2-2. The lower end of the second test bump 53-1 is disposed inside the second opening OP2-2. A second dummy bump 52-1 is disposed on the passivation layer 80-2.

The carrier bump 51-1 has a width of W4. The maximum width of the first opening OP1-2 has a width of W3a. W3a is less than W4. The planar area of the first opening OP1-2 may be less than the planar area of the carrier bump 51-1. The carrier bump 51-1 vertically overlaps the first opening OP1-2 and the passivation layer 80-2 around the first opening OP1-2. A third UBM pattern 72a vertically overlaps with the carrier bump 51-1. The third UBM pattern 72a is disposed between the carrier bump 51-1 and an external connection bump 61 and between the carrier bump 51-1 and the passivation layer 80-2.

A fourth UBM pattern 72b vertically overlaps the second dummy bump 52-1. The fourth UBM pattern 72b is interposed between the second dummy bump 52-1 and the passivation layer 80-2.

The planar area of the second opening OP2-2 is less than the planar area of the second test bump 53-1. The second test bump 53-1 vertically overlaps with the second opening OP2-2 and the passivation layer 80-2 around the second opening OP2-2. A fifth UBM pattern 72c vertically overlaps the second test bump 53-1. The fifth UBM pattern 72c is disposed between the second test bump 53-1 and the test pad 62, and between the second test bump 53-1 and the passivation layer 80-2.

The external connection bump 61 is formed under the third UBM pattern 72a and the passivation layer 80-2 around the third UBM pattern 72a which are exposed by removing the carrier substrate after removing the carrier substrate. The external connection bump 61 vertically overlaps the third UBM pattern 72a and the passivation layer 80-2 around the third UBM pattern 72a. The first UBM pattern 71a is disposed between the external connection bump 61 and the third UBM pattern 72a, and between the external connection bump 61 and the passivation layer 80-2.

The test pad 62 is formed on the fifth UBM pattern 72c and the passivation layer 80-2 around the fifth UBM pattern 72c that are exposed by removing the carrier substrate after removing the carrier substrate. The test pad 62 vertically overlaps the fifth UBM pattern 72c and the passivation layer 80-2 around the fifth UBM pattern 72c. The second UBM pattern 71b is disposed between the test pad 62 and the fifth UBM pattern 72c, and between the test pad 62 and the passivation layer 80-2.

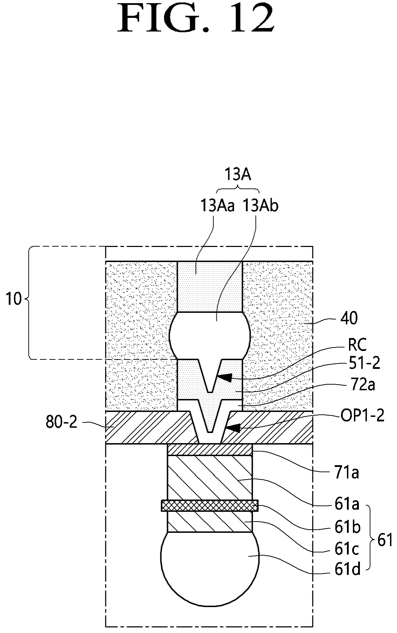

Referring to FIG. 12, the carrier bump 51-2 has a concave section RC on the upper surface contacting a solder layer 13Ab of a first front bump 13A. The concave section RC may have a shape corresponding to the shape of the first opening OP1-2 of the passivation layer 80-2. The solder layer 13Ab of the first front bump 13A is disposed in the concave section RC of the carrier bump 51-2. The concave section RC of the carrier bump 51-2 is filled with the solder layer 13Ab of the first front bump 13A.

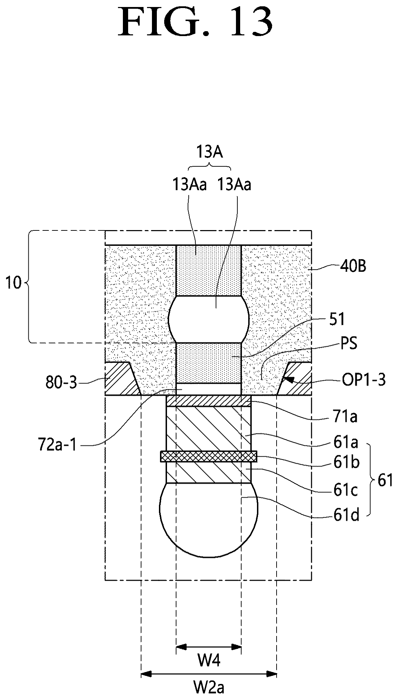

Referring to FIG. 13, the carrier bump 51 has a width of W4. The minimum width of the first opening OP1-3 has a width of W2a. W2a is greater than W4. The planar area of the first opening OP1-3 of the passivation layer 80-3 may be greater than the planar area of the carrier bump 51. The lower section of the carrier bump 51 is disposed inside the first opening OP1-3. The passivation layer 80-3 and the carrier bump 51 are disposed to be spaced apart from each other. The passivation layer 80-3 does not contact the carrier bump 51.

A protrusion PS of a mold member 40B is disposed between the passivation layer 80-3 and the carrier bump 51 inside the first opening OP1-3. The protrusion PS of the mold member 40B is disposed between the passivation layer 80-3 and the carrier bump 51. The protrusion PS of the mold member 40B is in contact with the passivation layer 80-3 and the carrier bump 51.

The planar area of the first opening OP1-3 of the passivation layer 80-3 is greater than the planar area of the external connection bump 61. The external connection bump 61 vertically overlaps the carrier bump 51 and the protrusion PS of the mold member 40. The first UBM pattern 71a is disposed between the external connection bump 61 and a third UBM pattern 72a-1, and between the external connection bump 61 and the protrusion PS of the mold member 40B.

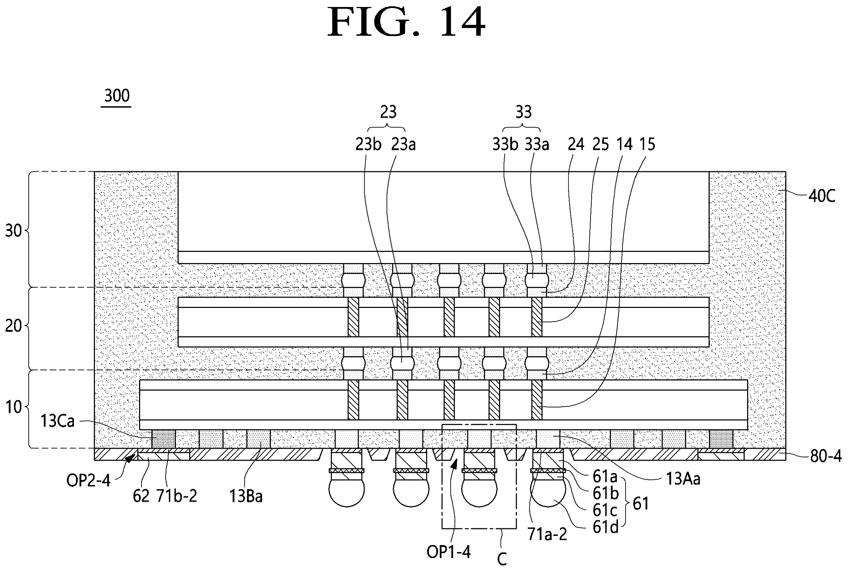

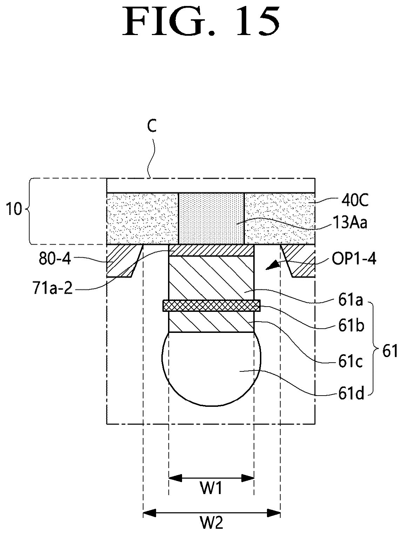

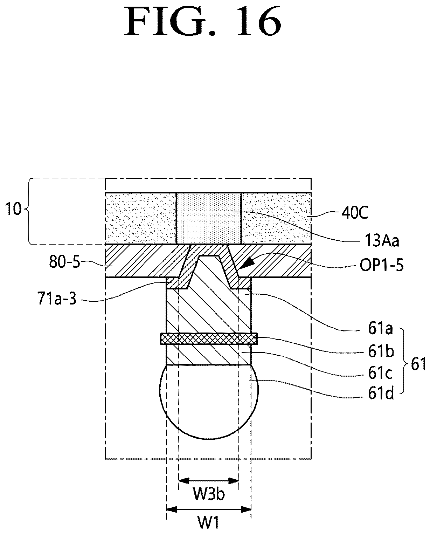

FIG. 14 is a cross-sectional view of a chip stack package according to an embodiment of the present disclosure, FIG. 15 is an enlarged view of a section C of FIG. 14, and FIG. 16 is a cross-sectional view illustrating a first front bump, an external bump, and passivation layer of a chip stack package according to an embodiment of the present disclosure.

Referring to FIG. 14 and FIG. 15, a conductive pillar 13Aa of a first front bump, a conductive pillar 13Ba of a first dummy bump, and a conductive pillar 13Ca of a first test bump of a chip stack package 300 are exposed to the lower surface of a mold member 40C. A lower surface of the conductive pillar 13Aa of a first front bump, a lower surface of the conductive pillar 13Ba of a first dummy bump, and a lower surface of a conductive pillar 13Ca of a first test bump may be disposed on the same plane as a lower surface of the mold member 40C.

The carrier substrate and a first seed layer of FIG. 8 is removed, and the surface exposed by the removal of the first seed layer may be polished to expose the conductive pillar 13Aa of the first front bump, the conductive pillar 13Ba of the first dummy bump, and the conductive pillar 13Ca of the first test bump. During the polishing process, the carrier bump 51 of FIG. 8, the second dummy bump 52 of FIG. 8, the second test bump 53 of FIG. 8, the solder layer 13Ab of the first front bump, the solder layer 13Bb of the first dummy bump, and the solder layer 13Cb of the first test bump may be removed.

The external connection bump 61 is disposed on the conductive pillar 13Aa of the first front bump. The external connection bump 61 includes a first copper layer 61a, a first nickel layer 61b, a second copper layer 61c, and a solder layer 61d.

A passivation layer 80-4 is disposed on the lower surface of a mold member 40C. A first opening OP1-4 is formed in the passivation layer 80-4 through which the conductive pillar 13Aa of the first front bump is exposed. A second opening OP2-4 is formed in the passivation layer 80-4 through which the conductive pillar 13Ca of the first test bump is exposed. The passivation layer 80-4 covers the conductive pillar 13Ba of the first dummy bump.

The first copper layer 61a of the external connection bump 61 has a width of W1. The minimum width of the first opening OP1-4 of the passivation layer 80-4 has a width of W2. W2 is greater than W1. The first opening OP1-4 of the passivation layer 80-4 has a greater planar area than the external connection bump 61. The external connection bump 61 and the passivation layer 80-4 is disposed spaced apart from each other. The passivation layer 80-4 does not contact with the external connection bump 61.

The first opening OP1-4 has a reverse tapered structure having a width that increases as the distance from the mold member 40C increases. A photosensitive material layer may be formed on the conductive pillar 13Aa of the mold member 40C and the first front bump. The first opening OP1-4 may be formed in the photosensitive material layer through an exposure and development process. After the first opening OP1-4 is formed, the photosensitive material layer may be hardened through a curing process to form the passivation layer 80-4. During the curing process, the photosensitive material layer may shrink, and the width of the shrinkage of the photosensitive material layer increases as the distance from the carrier substrate increases. Accordingly, the width of the first opening OP1-4 decreases as the distance from the mold member 40C decreases. The first opening OP1-4 has a reverse tapered structure in which the width increases as the distance from the mold member 40C increases.

The external connection bump 61 has a greater planar area than the conductive pillar 13Aa of the first front bump. The external connection bump 61 vertically overlaps the conductive pillar 13Aa and the mold member 40C around the conductive pillar 13Aa.

A first UBM pattern 71a-2 vertically overlaps the external connection bump 61. The first UBM pattern 71a-2 is disposed between the external connection bump 61 and the conductive pillar 13Aa, and between the external connection bump 61 and the mold member 40C.

A test pad 62 is disposed on the conductive pillar 13Ca of the first test bump. The test pad 62 has a greater planar area than the conductive pillar 13Ca of the first test bump. The test pad 62 vertically overlaps the conductive pillar 13Ca and the mold member 40C around the conductive pillar 13Ca. A second UBM pattern 71b-2 is disposed between the test pad 62 and the conductive pillar 13Ca and between the test pad 62 and the mold member 40C.

Referring to FIG. 16, the first copper layer 61a of the external connection bump 61 has a width of W1. The maximum width of a first opening OP1-5 of a passivation layer 80-5 has a width of W3b. W3b is less than W1. The planar area of the first opening OP1-5 may be less than the planar area of the external connection bump 61.

The external connection bump 61 vertically overlaps the conductive pillar 13Aa of the first front bump exposed through the first opening OP1-5 and the passivation layer 80-5 around the conductive pillar 13Aa. The first UBM layer 71a-3 vertically overlaps the external connection bump 61. The first UBM layer 71a-3 is disposed between the external connection bump 61 and the conductive pillar 13Aa, and between the external connection bump 61 and the passivation layer 80-5.

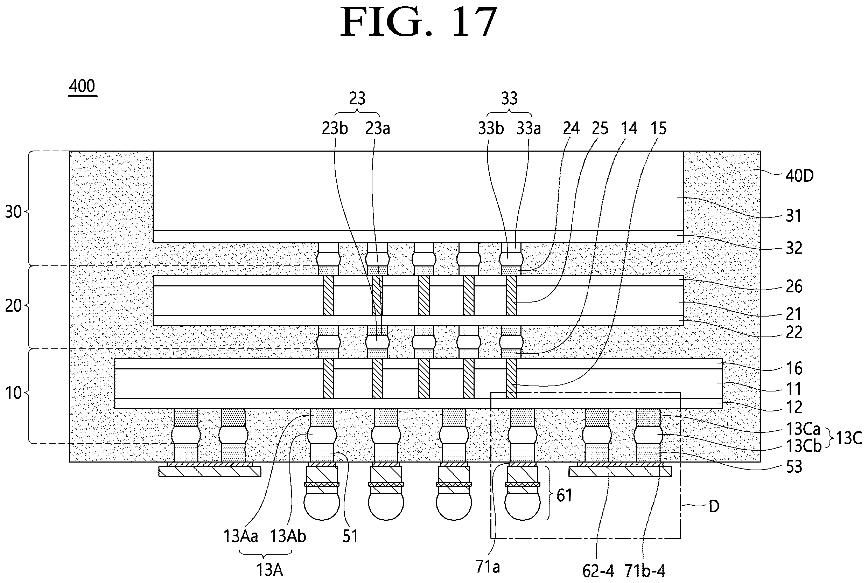

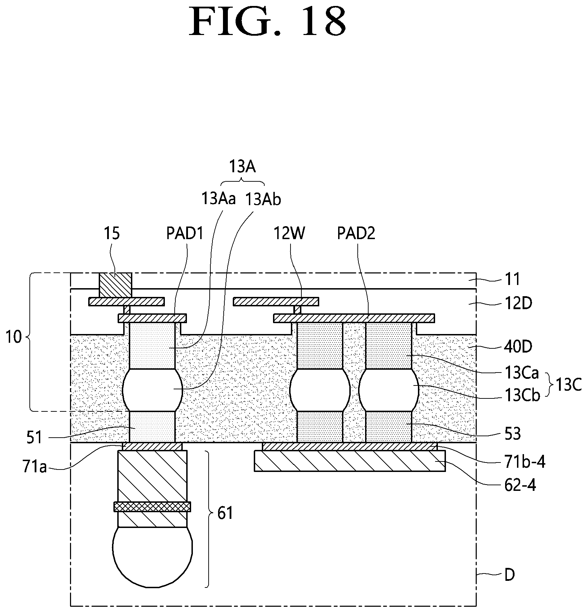

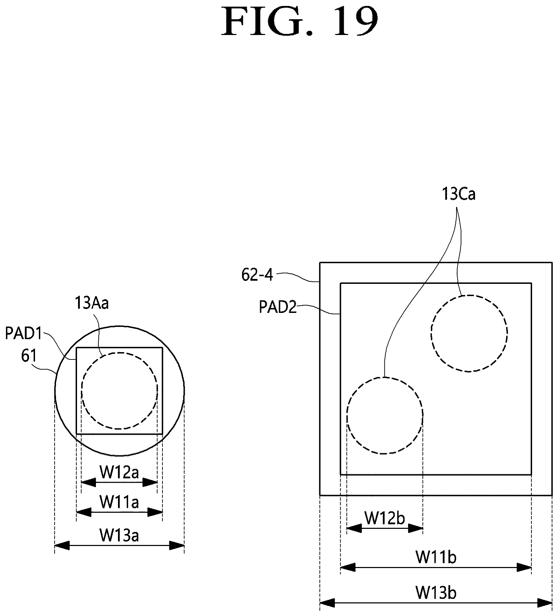

FIG. 17 is a cross-sectional view of a chip stack package according to an embodiment of the present disclosure, FIG. 18 is an enlarged view of section D of FIG. 17, and FIG. 19 is a plan view illustrating a first chip pad, a second chip pad, a first front bump, a first test bump, an external connection bump, and a test pad of FIG. 18.

Referring to FIG. 17, a chip stack package 400 according to an embodiment of the present disclosure includes two first test bumps 13C and two second test bumps 53 electrically connected between one test pad 62-4 and a first semiconductor chip 10.

Referring to FIG. 18, a first wiring structure 12 of the first semiconductor chip 10 includes an insulating layer 12D and a wiring 12W. The insulating layer 12D is disposed on a lower surface of a first substrate 11. The insulating layer 12D covers the lower surface of the first substrate 11. The wiring 12W is disposed within the insulating layer 12D. The wiring 12W includes a first chip pad PAD1 and a second chip pad PAD2. The insulating layer 12D has openings on its lower surface through which a first chip pad PAD1 and a second chip pad PAD2 are exposed, respectively.

The first substrate 11 includes a first integrated circuit. The first integrated circuit may include a Through-Silicon Via (TSV) region, a physical (PHY) region, and a design-for-test (DFT) region. The PHY region may include input/output circuitry for communication with an external device, such as a processor, of the chip stack package. The first chip pad PAD1 may be connected to the PHY region.

The DFT region may communicate with an external test device in a test mode. The DFT region may transmit signals provided from the test device to the TSV region. The second chip pad PAD2 may be connected to the DFT region.

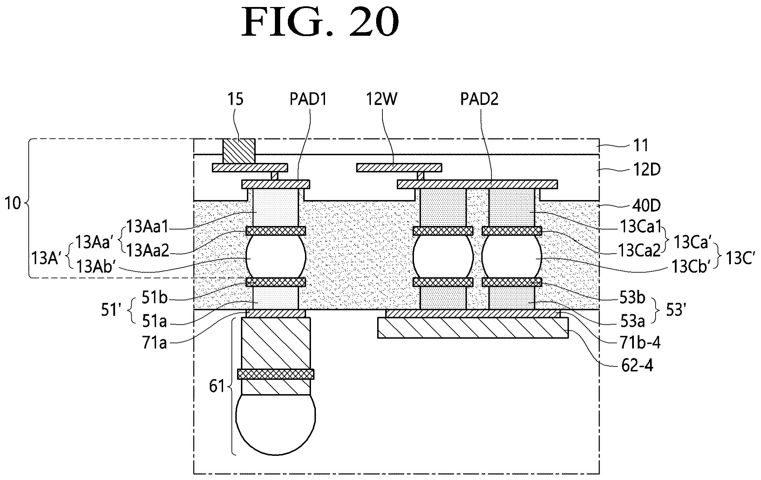

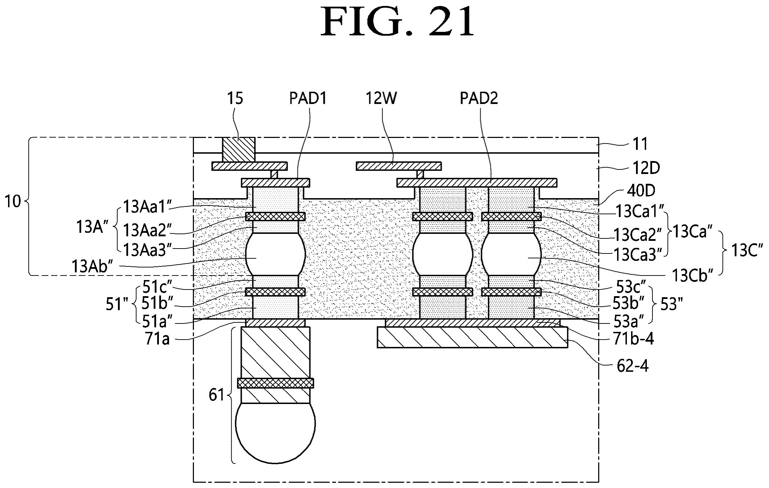

A first front bump 13A is disposed below the first chip pad PAD1. The first front bump 13A is connected to the first chip pad PAD1. The first front bump 13A includes a conductive pillar 13Aa and a solder layer 13Ab. The conductive pillar 13Aa is disposed under the first chip pad PAD1. The solder layer 13Ab is disposed under the conductive pillar 13Aa. In an embodiment, the conductive pillar 13Aa of the first front bump 13A may include nickel. The conductive pillar 13Aa of the first front bump 13A may be a nickel layer. Although the present embodiment exemplifies a case where the first front bump 13A is a nickel layer, other embodiments are not limited thereto. The first front bump may have a structure in which a copper layer and a nickel layer are stacked, as described below with reference to FIG. 20, or a structure in which a copper layer, a nickel layer, and a copper layer are stacked, as described below with reference to FIG. 21.

Although not shown, an UBM pattern (not shown) may be disposed between the first chip pad PAD1 and the conductive pillar 13Aa of the first front bump 13A. The UBM pattern may connect the first front bump 13A and the first chip pad PAD1. The UBM pattern may include a barrier metal layer disposed below the first chip pad PAD1 and a seed layer disposed below the barrier metal layer. The barrier metal layer may include titanium. The barrier metal layer may be a titanium layer. The seed layer may include copper. The seed layer may be a copper layer. The conductive pillar 13Aa of the first front bump 13A may be formed by a plating process using the seed layer.

The first front bump 13A of the first semiconductor chip 10 is bonded onto a carrier bump 51. The first front bump 13A of the first semiconductor chip 10 overlaps with the carrier bump 51, and the solder layer 13Ab of the first front bump 13A is bonded to the carrier bump 51.

In an embodiment, the carrier bump 51 may include nickel. The carrier bump 51 may be a nickel layer. Although the present embodiment exemplifies the case where the carrier bump 51 is a nickel layer, other embodiments are not limited thereto. The carrier bump may have a structure in which a copper layer and a nickel layer are stacked, as described later with reference to FIG. 20 , or a structure in which a copper layer, a nickel layer, and a copper layer are stacked, as described later with reference to FIG. 21 .

An external connection bump 61 is disposed below the carrier bump 51. A first UBM pattern 71a is disposed between the external connection bump 61 and the carrier bump 51. The first UBM pattern 71a connects the carrier bump 51 and the external connection bump 61.

A signal received from an external device through the external connection bump 61 is transmitted to the PHY region via the first UBM pattern 71a, the carrier bump 51, the first front bump 13A, and the first chip pad PAD1. The signal transmitted to the PHY region may then be transmitted to a second semiconductor chip 20 and a third semiconductor chip 30 via the TSV region, a first through-electrode 15, and a second through-electrode 25.

A first test bump 13C is disposed below the second chip pad PAD2. The first test bump 13C is connected to the second chip pad PAD2. The first test bump 13C includes a conductive pillar 13Ca and a solder layer 13Cb. A conductive pillar 13Ca is disposed below the second chip pad PAD2. A solder layer 13Cb is disposed below the conductive pillar 13Ca.

The conductive pillar 13Ca of the first test bump 13C may be formed simultaneously with the conductive pillar 13Aa of the first front bump 13A. The conductive pillar 13Ca of the first test bump 13C may include the same material as the conductive pillar 13Aa of the first front bump 13A.

Although not illustrated, an UBM pattern may be disposed between the second chip pad PAD2 and the conductive pillar 13Ca of the first test bump 13C. The UBM pattern may connect the second chip pad PAD2 and the first test bump 13C. The UBM pattern may include a barrier metal layer disposed below the second chip pad PAD2 and a seed layer disposed below the barrier metal layer. The barrier metal layer may include titanium. The barrier metal layer may be a titanium layer. The seed layer may include copper. The seed layer may be a copper layer. The conductive pillar 13Ca of the first test bump 13C may be formed through a plating process using the seed layer.

The solder layer 13Cb of the first test bump 13C may be formed simultaneously with the solder layer 13Ab of the first front bump 13A. The solder layer 13Cb of the first test bump 13C may include the same material as the solder layer 13Ab of the first front bump 13A.

Two first test bumps 13C may be disposed under one second chip pad PAD2. The two first test bumps 13C may be commonly connected to one second chip pad PAD2. Two second test bumps 53 may be bonded to the two first test bumps 13C, respectively.

The second test bump 53 may be formed simultaneously with the carrier bump 51. The second test bump 53 may be composed of the same material as the carrier bump 51. In an embodiment, the second test bump 53 may be a nickel layer.

The lower surface of the carrier bump 51 and the lower surface of the second test bump 53 may be exposed to the lower surface of the mold member 40D. The lower surface of the carrier bump 51 and the lower surface of the second test bump 53 may be disposed on the same plane as the lower surface of the mold member 40D.

The test pad 62-4 is disposed on the lower surface of the mold member 40D and the lower surfaces of the two second test bumps 53. The test pad 62-4 protrudes below the lower surface of the mold member 40D. Two second test bumps 53 are commonly connected to one test pad 62-4.

One of the first test bumps 13C and the second test bump 53 connected thereto constitute a first electrical path connecting the second chip pad PAD2 and the test pad 62-4. The remaining first test bumps 13C and the second test bumps 53 connected thereto constitute a second electrical path connecting the second chip pad PAD2 and the test pad 62-4. The first electrical path and the second electrical path are connected in parallel between one second chip pad PAD2 and one test pad 62-4.

In a test mode, a test pin placed on a probe card of a test device may contact the test pad 62-4 to apply a signal to the test pad 62-4. A signal applied to the test pad 62-4 is transmitted to the second chip pad PAD2 through the first electrical path and the second electrical path formed by two second test bumps 53 and two first test bumps 13C. The signal transmitted to the second chip pad PAD2 may be transmitted to the second semiconductor chip 20 and the third semiconductor chip 30 through the DFT region, the TSV region, the first through-electrode 15, and the second through-electrode 25.

Because two electrical paths are connected in parallel between the second chip pad PAD2 and the test pad 62-4, the resistance of the electrical path can be reduced compared to a case where only one electrical path is connected between the second chip pad and the test pad. Even if one of the two electrical paths is open, electrical connection may be established through the remaining path. Therefore, compared to a case where only one electrical path is configured between the second chip pad and the test pad, it is possible to reduce the possibility of a defect in which the second chip pad PAD2 and the test pad 62-4 are not connected.

In FIG. 18, the number of first test bumps 13C and the number of second test bumps 53 connected between one second chip pad PAD2 and one test pad 62-4 is two, but the present disclosure is not limited thereto. The number of first test bumps 13C and the number of second test bumps 53 connected between one second chip pad PAD2 and one test pad 62-4 may be one, three, or more.

Referring to FIG. 19, the first chip pad PAD1 has a width of W11a. The conductive pillar 13Aa of the first front bump has a width of W12a. W11a is greater than W12a. The planar area of the first chip pad PAD1 is greater than the planar area of the conductive pillar 13Aa of the first front bump. The external connection bump 61 has a width of W13a. W13a is greater than W11a and W12a. The planar area of the external connection bump 61 is greater than the planar area of the first chip pad PAD1 and the planar area of the conductive pillar 13Aa of the first front bump.

The second chip pad PAD2 has a width of W11b. The conductive pillar 13Ca of the first test bump has a width of W12b. W11b is greater than W12b. The planar area of the second chip pad PAD2 is greater than the planar area of the conductive pillar 13Ca of the first test bump.

The width of the test pad 62-4 is greater than the width of the second chip pad PAD2 and the width of the conductive pillar 13Ca of the first test bump. The test pad 62-4 has a width of W13b. W13b is greater than W11b and W12b. The planar area of the test pad 62-4 is greater than the planar area of the second chip pad PAD2 and the planar area of the conductive pillar 13Ca of the first test bump.

The width of the second chip pad PAD2 is greater than the width of the first chip pad PAD1. W11b is greater than W11a. The planar area of the second chip pad PAD2 is greater than the planar area of the first chip pad PAD1.

The width of the conductive pillar 13Aa of the first front bump and the width of the conductive pillar 13Ca of the first test bump may be the same. W12a and W12b may be the same. The size of the conductive pillar 13Aa of the first front bump and the size of the conductive pillar 13Ca of the first test bump may be the same.

Unlike an embodiment of the present disclosure, if the conductive pillar of the first front bump and the conductive pillar of the first test bump, which are produced in the same process, have different sizes, there is a possibility that process defects may occur due to process imbalance caused by size mismatch between patterns. According to an embodiment of the present disclosure, the conductive pillar 13Aa of the first front bump and the conductive pillar 13Ca of the first test bump, which are produced in the same process, have the same size, thereby reducing, mitigating, suppressing, or preventing process defects.

The width of the test pad 62-4 is greater than the width of the external connection bump 61. W13b is greater than W13a. The planar area of the test pad 62-4 is greater than the planar area of the external connection bump 61.

A test can be conducted in various temperature ranges in order to test the operational reliability of the chip stack package according to temperature changes. Temperature changes may cause the chip stack package to contract and expand, which may change the position of the second chip pad.

Unlike an embodiment of the present disclosure, the probe pin of a test device may be directly contact the second chip pad of the first semiconductor chip without a test pad. Due to integration and circuit speed increases, the sizes of components included in the first semiconductor chip are gradually decreasing, and the size of the second chip pad is also decreasing accordingly. As the size of the second chip pad decreases, an alignment margin between the probe pin and the second chip pad may become tighter when the probe pin is brought into contact with the second chip pad. During testing, temperature changes can cause the position of the second chip pad to change, and the alignment margin between the probe pin and the second chip pad may become tight. Therefore, there is a possibility that the probe pin will contact a section other than the second chip pad. This can damage the first semiconductor chip and result in a test failure.

Because the second chip pad is positioned farther inward than the lower surface of the wiring structure of the first semiconductor chip, when the probe pin contacts the second chip pad, the probe card may collide with the external connection bumps around the second chip pad, which may damage the external connection bumps. It is possible to prevent the probe card from colliding with the external connection bumps around the second chip pad by increasing the length of the probe pin. However, as the length of the probe pin increases, the resistance of the probe pin also increases, which may increase the measurement error during testing.

According to an embodiment of the present disclosure, a test pad 62-4 may be configured under the mold member 40D, thereby enabling the test pad 62-4 to be configured in a large size without being restricted by the design of the first semiconductor chip 10. Accordingly, the alignment margin between the probe pin and the test pad 62-4 is improved, thereby suppressing or preventing the probe pin from contacting a section other than the test pad 62-4.

According to an embodiment of the present disclosure, because the test pad 62-4 protrudes beyond the surface of the mold member 40D, even if a long probe pin is not used, the probe card does not collide with the external connection bump 61 when the probe pin contacts the test pad 62-4. Accordingly, it is possible to use a short probe pin, thereby reducing the resistance of the probe pin and reducing measurement errors during testing.

FIG. 20 and FIG. 21 are drawings for explaining a first front bump, a carrier bump, a first test bump, and a second test bump of a chip stack package according to embodiments of the present disclosure.

Referring to FIG. 20, a first front bump 13A' has the same structure as the front bump described with reference to FIG. 3. A first test bump 13C' has the same structure as the first front bump 13A'. A conductive pillar 13Ca' of the first test bump 13C' has the same structure as the conductive pillar 13Aa' of the first front bump 13A'. The conductive pillar 13Ca' of the first test bump 13C' may be formed together with the conductive pillar 13Aa' of the first front bump 13A' in the process of forming the conductive pillar 13Aa' of the first front bump 13A'.

The conductive pillar 13Ca' of the first test bump 13C' includes a copper layer 13Ca1 and a nickel layer 13Ca2 below the copper layer 13Ca1. The nickel layer 13Ca2 is disposed on the lower surface of the copper layer 13Ca1. The nickel layer 13Ca2 is disposed between the copper layer 13Ca1 and a solder layer 13Cb'.

The thickness of the copper layer 13Ca1 is greater than that of the nickel layer 13Ca2. The copper layer 13ca1, which is made of copper with a lower resistivity than nickel, can be formed thicker than the nickel layer 13Ca2 to ensure that the first test bump 13C' has higher electrical conductivity. Although not shown, a copper-solder intermetallic compound is formed at an interface between the conductive pillar 13Ca' and the solder layer 13Cb'. The nickel layer 13Ca2 can prevent the copper contained in the copper layer 13Ca1 from diffusing to the interface between the conductive pillar 13Ca' and the solder layer 13Cb', thereby suppressing the formation of a thick copper-solder intermetallic compound.

The side surfaces of the nickel layer 13Ca2 may protrude farther than the side surfaces of the copper layer 13ca1. The central section of the nickel layer 13Ca2 may overlap with the copper layer 13Ca1, and the flange section of the nickel layer 13Ca2 might not overlap with the copper layer 13Ca1.

A carrier bump 51' has the same structure as the carrier bump described with reference to FIG. 3. A second test bump 53' has the same structure as the carrier bump 51'. The second test bump 53' includes a copper layer 53a and a nickel layer 53b on the copper layer 53a. The nickel layer 53b covers the upper surface of the copper layer 53a. The nickel layer 53b is disposed between the copper layer 53a and a solder layer 13Cb'. The thickness of the copper layer 53a is greater than the thickness of the nickel layer 53b. The copper layer 53a, which is made of copper having a lower resistivity than nickel, can be formed thicker than the nickel layer 53b so that the second test bump 53' has higher electrical conductivity.

Although not shown, when bonding the second test bump 53' and the solder layer 13Cb', a copper-solder intermetallic compound may be formed at an interface between the second test bump 53' and the solder layer 13Cb'. The nickel layer 53b can prevent the copper included in the copper layer 53a from diffusing to the interface between the second test bump 53' and the solder layer 13Cb', thereby suppressing the formation of a thick copper-solder intermetallic compound.

Referring to FIG. 21, the first front bump 13A" includes a conductive pillar 13Aa" and a solder layer 13Ab" below the conductive pillar 13Aa". The conductive pillar 13Aa includes a third copper layer 13Aa1", a first nickel layer 13Aa2" below the third copper layer 13Aa1", and a fourth copper layer 13Aa3" below the first nickel layer 13Aa2". A solder layer 13Ab is disposed below the fourth copper layer 13Aa3".

The thickness of the third copper layer 13Aa1" may be greater than the thickness of the first nickel layer 13Aa2". The third copper layer 13Aa1", which is made of copper having a lower resistivity than nickel, may be formed thicker than the first nickel layer 13Aa2", thereby enabling the first front bump 13A" to have higher electrical conductivity.

The first nickel layer 13Aa2" is interposed between the third copper layer 13Aa1" and the fourth copper layer 13Aa3". A copper-solder intermetallic compound (not shown) may be formed between the conductive pillar 13Aa" and the solder layer 13Ab". The first nickel layer 13Aa2" may suppress copper included in the third copper layer 13Aa1" from diffusing to the interface between the conductive pillar 13Aa" and the solder layer 13Ab", thereby suppressing the formation of a thick copper-solder intermetallic compound. The side surface of the first nickel layer 13Aa2" may protrude beyond the side surface of the third copper layer 13Aa1" and the side surface of the fourth copper layer 13Aa3". The central section of the first nickel layer 13Aa2" may overlap with the third copper layer 13Aa1" and the fourth copper layers 13Aa3", and the flange section of the first nickel layer 13Aa2" might not overlap with the third copper layer 13Aa1" and the fourth copper layers 13Aa3".

The fourth copper layer 13Aa3" is interposed between the first nickel layer 13Aa2" and the solder layer 13Ab". Because the fourth copper layer 13Aa3" is disposed between the first nickel layer 13Aa2" and the solder layer 13Ab", the formation of a nickel-solder intermetallic compound can be suppressed.

The thickness of the fourth copper layer 13Aa3" is less than the thickness of the third copper layer 13Aa1". Because the copper included in the third copper layer 13Aa1" is suppressed from diffusing to the interface between the conductive pillar 13Aa" and the solder layer 13Ab" by the first nickel layer 13Aa2", and the fourth copper layer 13Aa3" has a thickness less than the third copper layer 13Aa1", a copper-solder intermetallic compound can be formed as a thin film between the conductive pillar 13Aa" and the solder layer 13Ab".

The carrier bump 51" includes a fifth copper layer 51a", a second nickel layer 51b" on the fifth copper layer 51a", and a sixth copper layer 51c" on the second nickel layer 51b". The thickness of the fifth copper layer 51a" may be greater than the thickness of the second nickel layer 51b". The fifth copper layer 51a" made of copper having a lower resistivity than nickel may be formed thicker than the second nickel layer 51b", so that the carrier bump 51" can have higher electrical conductivity.

The second nickel layer 51b" is interposed between the fifth copper layer 51a" and the sixth copper layer 51c". A copper-solder intermetallic compound (not shown) may be formed between the carrier bump 51" and the solder layer 13Ab". The second nickel layer 51b" may suppress copper included in the fifth copper layer 51a" from diffusing to the interface between the carrier bump 51" and the solder layer 13Ab", thereby suppressing the formation of a thick copper-solder intermetallic compound. The side surface of the second nickel layer 51b" may protrude beyond the side surface of the fifth copper layer 51a" and the side surface of the sixth copper layer 51c". The central section of the second nickel layer 51b" overlaps with the fifth copper layers 51a" and the sixth copper layer 51c", and the flange section of the second nickel layer 51b" might not overlap with the fifth copper layers 51a" and the sixth copper layer 51c".

The sixth copper layer 51c" is interposed between the second nickel layer 51b" and the solder layer 13Ab". Because the sixth copper layer 51c" is disposed between the second nickel layer 51b" and the solder layer 13Ab", the formation of a nickel-solder intermetallic compound can be suppressed.

The thickness of the sixth copper layer 51c" is less than the thickness of the fifth copper layer 51a". Because the copper included in the fifth copper layer 51a" is suppressed from diffusing into the interface between the carrier bump 51" and the solder layer 13Ab" by the second nickel layer 51b", and the sixth copper layer 51c" has a less thickness than the fifth copper layer 51a", a copper-solder intermetallic compound can be formed as a thin film between the carrier bump 51" and the solder layer 13Ab".

The solder layer 13Ab" is interposed between the fourth copper layer 13Aa3" of the first front bump 13A" and the sixth copper layer 51c" of the carrier bump 51". The solder layer 13Ab" contacts the fourth copper layer 13Aa3" of the first front bump 13A" and the sixth copper layer 51c" of the carrier bump 51".

The first test bump 13C" may have the same structure as the first front bump 13A". The first test bump 13C" includes a conductive pillar 13Ca" and a solder layer 13Cb" below the conductive pillar 13Ca". The conductive pillar 13Ca" includes a seventh copper layer 13Ca1", a third nickel layer 13Ca2" below the seventh copper layer 13Ca1", and an eighth copper layer 13Ca3" below the third nickel layer 13Ca2". A solder layer 13Cb" is disposed below the eighth copper layer 13Ca3".

The thickness of the seventh copper layer 13Cal" may be greater than the thickness of the third nickel layer 13Ca2". The seventh copper layer 13Ca1", which is made of copper with a lower resistivity than nickel, can be formed thicker than the third nickel layer 13Ca2", so that the first test bump 13C" has higher electrical conductivity.

The third nickel layer 13Ca2" is interposed between the seventh copper layer 13Ca1" and the eighth copper layer 13Ca3". A copper-solder intermetallic compound (not shown) can be formed between the conductive pillar 13Ca" and the solder layer 13Cb". The third nickel layer 13Ca2" can suppress the copper contained in the seventh copper layer 13Ca1" from diffusing to the interface between the conductive pillar 13Ca" and the solder layer 13Cb", thereby suppressing the formation of a thick copper-solder intermetallic compound. The side surface of the third nickel layer 13Ca2" may protrude beyond the side surface of the seventh copper layer 13Ca1" and the side surface of the eighth copper layer 13Ca3". The central section of the third nickel layer 13Ca2" may overlap with the seventh copper layer 13Ca1" and the eighth copper layer 13Ca3", and the flange section of the third nickel layer 13Aa2" might not overlap with the seventh copper layer 13Ca1" and the eighth copper layer 13Ca3".

The eighth copper layer 13Ca3" is interposed between the third nickel layer 13Ca2" and the solder layer 13Cb". Because the eighth copper layer 13Ca3" is disposed between the third nickel layer 13Ca2" and the solder layer 13Cb", the formation of a nickel-solder intermetallic compound can be suppressed.

The thickness of the eighth copper layer 13Ca3" is less than the thickness of the seventh copper layer 13Ca1". Because the copper contained in the seventh copper layer 13Ca1" is suppressed from diffusing to the interface between the conductive pillar 13Ca" and the solder layer 13Cb" by the third nickel layer 13Ca2", and the eighth copper layer 13Ca3" has a thickness less than the seventh copper layer 13Ca1", a copper-solder intermetallic compound can be formed as a thin film between the conductive pillar 13Ca" and the solder layer 13Cb".

The second test bump 53" includes a ninth copper layer 53a", a fourth nickel layer 53b" on the ninth copper layer 53a", and a tenth copper layer 53c" on the fourth nickel layer 53b". A solder layer 13Cb" is bonded on the tenth copper layer 53c". The thickness of the ninth copper layer 53a" may be greater than the thickness of the fourth nickel layer 53b". The ninth copper layer 53a" made of copper having a lower resistivity than nickel may be formed thicker than the fourth nickel layer 53b", so that the second test bump 52" can be configured to have higher electrical conductivity.

The fourth nickel layer 53b" is interposed between the ninth copper layer 53a" and the tenth copper layer 53c". A copper-solder intermetallic compound may be formed between the second test bump 53" and the solder layer 13Cb". The fourth nickel layer 53b" may suppress copper included in the ninth copper layer 53a" from diffusing to the interface between the second test bump 53" and the solder layer 13Cb", thereby suppressing the formation of a thick copper-solder intermetallic compound. The side surface of the fourth nickel layer 53b" may protrude beyond the side surface of the ninth copper layer 53a" and the side surface of the tenth copper layer 53c". The central section of the fourth nickel layer 53b" overlaps with the ninth copper layer 53a" and tenth copper layer 53c", and the flange section of the fourth nickel layer 53b" might not overlap with the ninth copper layer 53a" and tenth copper layer 53c".

The tenth copper layer 53c" is interposed between the fourth nickel layer 53b" and the solder layer 13Cb". The tenth copper layer 53c" is disposed between the fourth nickel layer 53b" and the solder layer 13Cb", so that it is possible to suppress the formation of a nickel-solder intermetallic compound.

The thickness of the tenth copper layer 53c" is less than the thickness of the ninth copper layer 53a". The fourth nickel layer 53b" suppresses the copper contained in the ninth copper layer 53a" from diffusing into the interface between the second test bump 53" and the solder layer 13Cb", and the tenth copper layer 53c" has a less thickness than the ninth copper layer 53a", so that a copper-solder intermetallic compound may be formed as a thin film between the second test bump 53" and the solder layer 13Cb".

The solder layer 13Cb" is interposed between the eighth copper layer 13Ca3" of the first test bump 13C" and the tenth copper layer 53c" of the second test bump 53". The solder layer 13Cb" contacts the eighth copper layer 13Ca3" of the first test bump 13C" and the tenth copper layer 53c" of the second test bump 53".

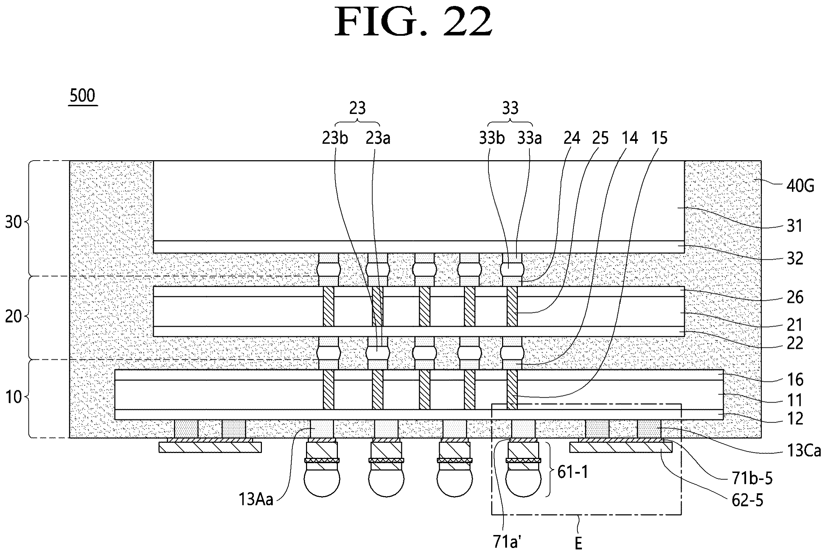

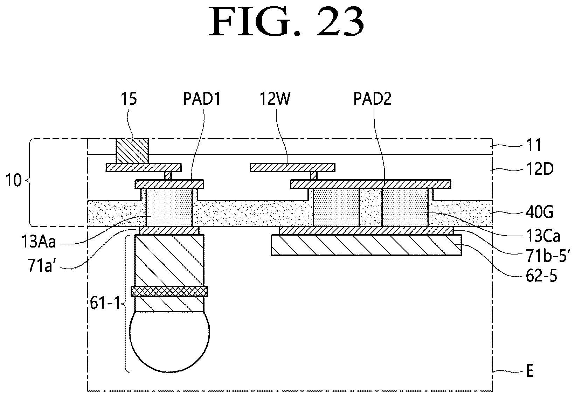

FIG. 22 is a cross-sectional view of a chip stack package according to an embodiment of the present disclosure, and FIG. 23 is an enlarged view of section E of FIG. 22.

Referring to FIG. 22, in a chip stack package 500 according to an embodiment of the present disclosure, the lower surface of the conductive pillar 13Aa of the front bump and the lower surface of the conductive pillar 13Ca of the first test bump are exposed through the lower surface of the mold member 40G. The lower surface of the conductive pillar 13Aa of the front bump and the lower surface of the conductive pillar 13Ca of the first test bump may be disposed on the same plane as the lower surface of the mold member 40G.

The conductive pillars 13Ca of two first test bumps are connected between one test pad 62-4 and the first semiconductor chip 10. The conductive pillars 13Ca of two first test bumps are commonly connected to a single test pad 62-4.

Referring to FIG. 23, the conductive pillar 13Aa of the first front bump is disposed below the first chip pad PAD1. The conductive pillar 13Aa of the first front bump is connected to the first chip pad PAD1.

The external connection bump 61-1 is disposed below the conductive pillar 13Aa of the first front bump. The external connection bump 61-1 has a greater planar area than the conductive pillar 13Aa of the first front bump. The external connection bump 61-1 overlaps with the conductive pillar 13Aa and the mold member 40G surrounding the conductive pillar 13Aa.

The first UBM pattern 71a' overlaps with the external connection bump 61-1. The first UBM pattern 71a' is disposed between the external connection bump 61-1 and the conductive pillar 13Aa of the first front bump, and between the external connection bump 61-1 and the mold member 40G. The first UBM pattern 71a' connects the external connection bump 61-1 and the conductive pillar 13Aa of the first front bump.

The conductive pillar 13Ca of the first test bump is disposed below the second chip pad PAD2. The conductive pillars 13Ca of two first test bumps are disposed below one second chip pad PAD2. The conductive pillars 13Ca of two first test bumps are commonly connected to one second chip pad PAD2. The conductive pillar 13Ca of the first test bump may be formed simultaneously with the conductive pillar 13Aa of the front bump. The conductive pillar 13Ca of the first test bump may formed of the same material as the conductive pillar 13Aa of the front bump.

The test pad 62-5 is disposed below the mold member 40G and the conductive pillar 13Ca of the first test bump. The test pad 62-5 protrudes below the lower surface of the mold member 40G. The test pad 62-5 overlaps with the conductive pillars 13Ca of the two first test bumps and the mold member 40G surrounding the conductive pillars 13Ca of the two first test bumps. The conductive pillars 13Ca of the two first test bumps are commonly connected to one test pad 62-5. The conductive pillars 13Ca of the two first test bumps form a first electrical path and a second electrical path connecting the second chip pad PAD2 and the test pad 62-5. Two electrical paths are connected in parallel between the second chip pad PAD2 and the test pad 62-5.

A second UBM pattern 71b-5 overlaps with the test pad 62-5. The second UBM pattern 71b-5 is disposed between the test pad 62-5 and the conductive pillar 13Ca of the first test bump, and between the test pad 62-5 and the mold member 40G. The second UBM pattern 71b-5 connects the test pad 62-5 and the conductive pillar 13Ca.

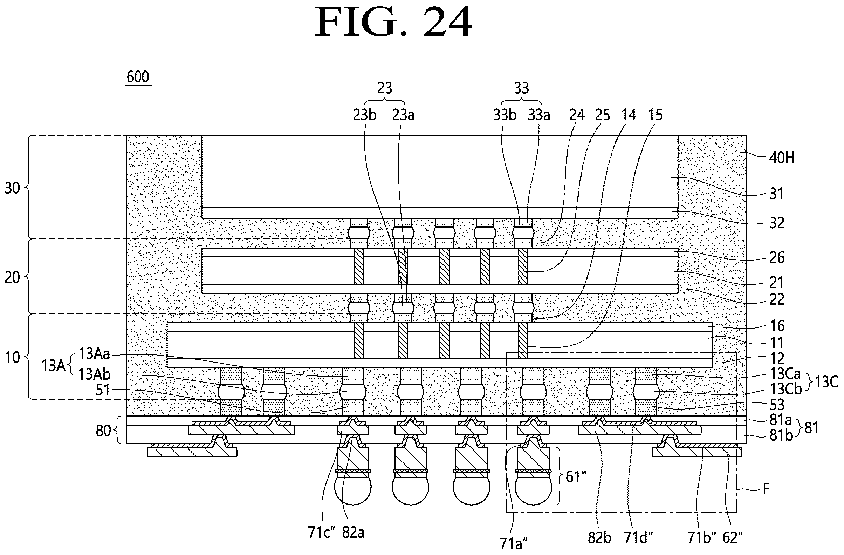

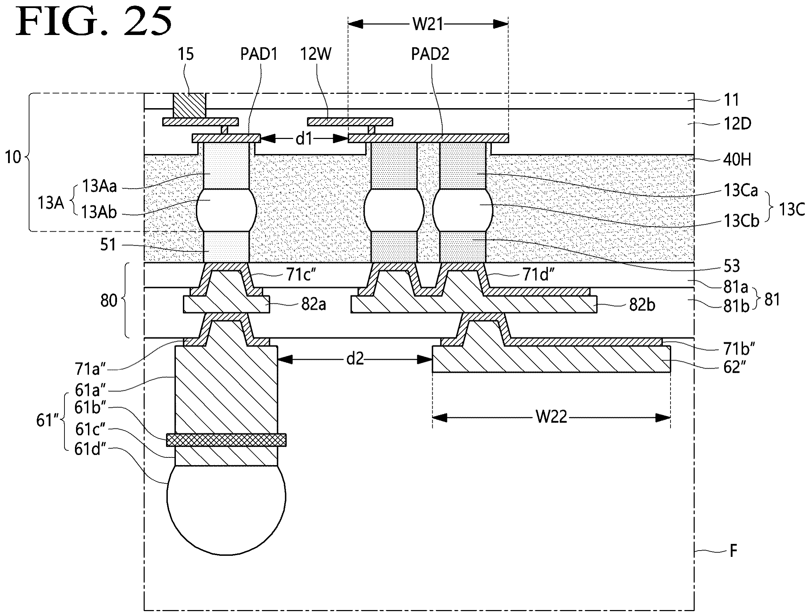

FIG. 24 is a cross-sectional view of a chip stack package according to an embodiment of the present disclosure, and FIG. 25 is an enlarged view of section F of FIG. 23.

Referring to FIG. 24 and FIG. 25, a chip stack package 600 according to an embodiment of the present disclosure includes a first semiconductor chip 10, a second semiconductor chip 20, and a third semiconductor chip 30, a mold member 40H, a carrier bump 51, a second test bump 53, a redistribution layer 80, an external connection bump 61", and a test pad 62".

The second semiconductor chip 20 is stacked on a first semiconductor chip 10, and the third semiconductor chip 30 is stacked on the second semiconductor chip 20.

The first semiconductor chip 10 is connected to the carrier bump 51 and the second test bump 53 by a first front bump 13A and a first test bump 13C. The first front bump 13A of the first semiconductor chip 10 is disposed on the carrier bump 51, and a solder layer 13Ab of the first front bump 13A is bonded to the carrier bump 51. The first test bump 13C of the first semiconductor chip 10 is disposed on the second test bump 53, and the solder layer 13Cb of the first test bump 13C is bonded to the second test bump 53. The first semiconductor chip 10 is physically and electrically connected to the carrier bump 51 through the first front bump 13A. The first semiconductor chip 10 is physically and electrically connected to the second test bump 53 through the first test bump 13C.

The mold member 40H surrounds the first semiconductor chip 10, the second semiconductor chip 20, the third semiconductor chip 30, the carrier bump 51, and the second test bump 53. The lower surface of the carrier bump 51 and the lower surface of the second test bump 53 are exposed to the lower surface of the mold member 40H. The lower surface of the carrier bump 51 and the lower surface of the second test bump 53 are arranged on the same plane as the lower surface of the mold member 40H.

The redistribution layer 80 is disposed on the lower surface of the mold member 40H, the lower surface of the carrier bump 51, and the lower surface of the second test bump 53. The redistribution layer 80 includes a dielectric layer 81 and connection lines 82a and 82b. The dielectric layer 81 may include an insulating material. The insulating material may include a polymer-based photosensitive material. The connection lines 82a and 82b may be metal wirings. The metal wirings may include copper (Cu).

The dielectric layer 81 may include a first dielectric layer 81a and a second dielectric layer 81b below the first dielectric layer 81a. The first dielectric layer 81a is disposed on the lower surface of the mold member 40H, the lower surface of the carrier bump 51, and the lower surface of the second test bump 53.

The connection lines include a first connection line 82a and a second connection line 82b. The first connection line 82a includes a via section and a wiring section. The via section of the first connection line 82a vertically penetrates the first dielectric layer 81a and is connected to the corresponding carrier bump 51. The wiring section of the first connection line 82a is disposed below the via section of the first connection line 82a and the first dielectric layer 81a. The via section of the first connection line 82a and the wiring section of the first connection line 82a may be formed integrally.

A third UBM pattern 71c" overlaps with the first connection line 82a. The third UBM pattern 71c" may be disposed between the first connection line 82a and the carrier bump 51, and between the first connection line 82a and the first dielectric layer 81a. The third UBM pattern 71c" may connect the first connection line 82a and the carrier bump 51.

The third UBM pattern 71c" may include a barrier metal layer disposed under the carrier bump 51 and the first dielectric layer 81a, and a seed layer disposed under the barrier metal layer. The barrier metal layer may include titanium. The barrier metal layer may be a titanium layer. The seed layer may include copper. The seed layer may be a copper layer. The first connection line 82a may be formed by a plating process using the seed layer.

The second connection line 82b includes via sections and a wiring section. The second connection line 82b includes two via sections and one wiring section. Each of the via sections of the second connection line 82b vertically penetrates the first dielectric layer 81a and is connected to a corresponding second test bump 53. The second connection line 82b is commonly connected to two second test bumps 53 via two via sections. The wiring section of the second connection line 82b is disposed below the via sections of the second connection line 82b and the first dielectric layer 81a. The via sections of the second connection line 82b and the wiring section of the second connection line 82b may be formed integrally.

In FIG. 24 and FIG. 25, the number of second test bumps 53 connected to one second connection line 82b is two, but the present disclosure is not limited thereto. In other embodiments, the number of second test bumps connected to one second connection line may be one, three, or more.

A fourth UBM pattern 71d" may overlap with the second connection line 82b. The fourth UBM pattern 71d" may be disposed between the second connection line 82b and the second test bump 53, and between the second connection line 82b and the first dielectric layer 81a. The fourth UBM pattern 71d" may connect the second connection line 82b and the second test bump 53.

The fourth UBM pattern 71d" may include a barrier metal layer disposed under the second test bump 53 and the first dielectric layer 81a, and a seed layer disposed under the barrier metal layer. The barrier metal layer may include titanium. The barrier metal layer may be a titanium layer. The seed layer may include copper. The seed layer may be a copper layer. The second connection line 82b may be formed by a plating process using the seed layer.

The second dielectric layer 81b is disposed below the first dielectric layer 81a, the first connection line 82a, and the second connection line 82b. The second dielectric layer 81b covers the lower surface of the first dielectric layer 81a, the side surface and lower surface of the first connection line 82a, and the side surface and lower surface of the second connection line 82b.

An external connection bump 61" is disposed under the redistribution layer 80. The external connection bump 61" vertically penetrates the second dielectric layer 81b and is connected to the first connection line 82a. The external connection bump 61" includes a first copper layer 61a, a nickel layer 61b under the first copper layer 61a, a second copper layer 61c under the nickel layer 61b, and a solder layer 61d under the second copper layer 61c. The first copper layer 61a of the external connection bump 61" vertically penetrates the second dielectric layer 81b and is connected to the first connection line 82a. The first UBM pattern 71a" overlaps with the external connection bump 61". The first UBM pattern 71a" is disposed between the external connection bump 61" and the first connection line 82a, and between the external connection bump 61" and the second dielectric layer 81b. The first UBM pattern 71a" connects the external connection bump 61" and the first connection line 82a.

The test pad 62" is disposed below the redistribution layer 80. The lower surface of the test pad 62" is arranged below the lower surface of the redistribution layer 80. The test pad 62" vertically penetrates the second dielectric layer 81b and is connected to the second connection line 82b. The test pad 62" includes a via section that vertically penetrates the second dielectric layer 81b. The second UBM pattern 17b" is arranged between the test pad 62" and the second connection line 82b, and between the test pad 62" and the second dielectric layer 81b. The second UBM pattern 17b" connects the test pad 62" and the second connection line 82b.

The width of the test pad 62" is greater than the width of the second chip pad PAD2. As illustrated in FIG. 25, the width of the second chip pad PAD2 is W21. The width of the test pad 62" is W22. W22 is greater than W21.

The distance or gap between the test pad 62" and an external connection bump 61" closest to the test pad 62" is greater than the distance or gap between the second chip pad PAD2 and the first chip pad PAD1 closest to the second chip pad PAD2. The distance between the second chip pad PAD2 and the first chip pad PAD1 closest to the second chip pad PAD2is d1. The distance between the test pad 62" and the external connection bump 61" closest to the test pad 62" is d2. The d2 is greater than d1.

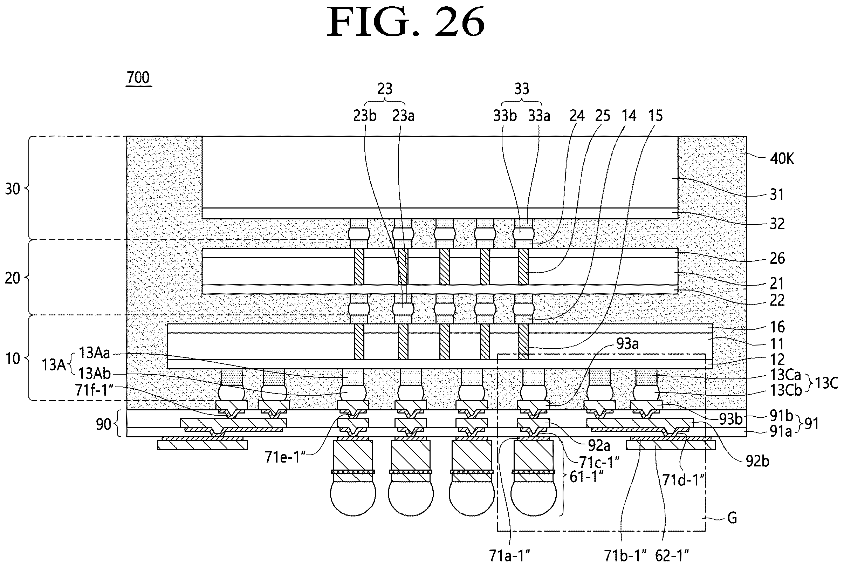

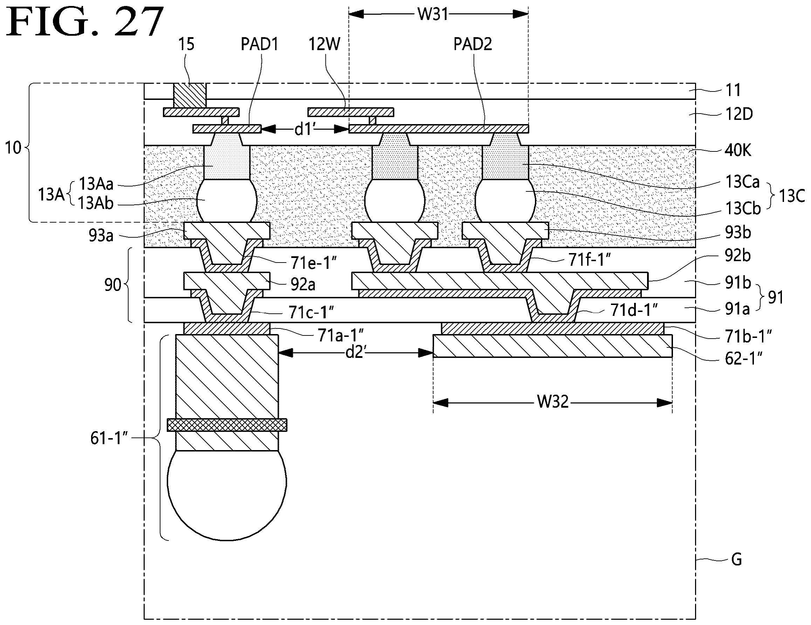

FIG. 26 is a cross-sectional view of a chip stack package according to an embodiment of the present disclosure, and FIG. 27 is an enlarged view of section G of FIG. 26.

Referring to FIG. 26 and FIG. 27, a chip stack package 700 according to an embodiment of the present disclosure includes a redistribution substrate 90, a first semiconductor chip 10, a second semiconductor chip 20, a third semiconductor chip 30, a mold member 40K, an external connection bump 61-1", and a test pad 62-1".

The redistribution substrate 90 includes a first connection lines 92a, a second connection line 92b, a first bump pad 93a, a second bump pad 93b, and a dielectric layer 91. The dielectric layer 91 may include an insulating material. The insulating material may include a polymer-based photosensitive material. The dielectric layer 91 includes a first dielectric layer 91a and a second dielectric layer 91b on the first dielectric layer 91a. The first connection lines 92a, the second connection line 92b, the first bump pad 93a, and the second bump pad 93b may be metal wirings. The metal wirings may include copper.

The first connection line 92a vertically penetrates the first dielectric layer 91a and extends on the upper surface of the first dielectric layer 91a. The first connection line 92a includes a via section and a wiring section. The via section of the first connection line 92a vertically penetrates the first dielectric layer 91a. The wiring section of the first connection line 92a is disposed on the via section of the first connection line 92a and the first dielectric layer 91a. The via section of the first connection line 92a and the wiring section of the first connection line 92a may be formed integrally.

The second connection line 92b vertically penetrates the first dielectric layer 91a and extends on the upper surface of the first dielectric layer 91a. The second connection line 92b includes a via section and a wiring section. The via section of the second connection line 92b vertically penetrates the first dielectric layer 91a. The wiring section of the second connection line 92b is formed on the via section of the second connection line 92b and the first dielectric layer 91a. The via section of the second connection line 92b and the wiring section of the second connection line 92b may be formed integrally.

The external connection bump 61-1" is disposed below the redistribution substrate 90. The via section of the first connection line 92a penetrates the first dielectric layer 91a and is connected to the external connection bump 61-1". The external connection bump 61-1" overlaps with the via section of the first connection line 92a and the first dielectric layer 91a surrounding the via section of the first connection line 92a.

A first UBM pattern 71b-1" is disposed on the external connection bump 61-1". The first UBM pattern 71b-1" is interposed between the external connection bump 61-1" and the first connection line 92a, and between the external connection bump 61-1" and the first dielectric layer 91a. The first UBM pattern 71a-1" connects the external connection bump 61-1" and the first connection line 92a.

A test pad 62-1" is disposed below the redistribution substrate 90. The via section of the second connection line 92b penetrates the first dielectric layer 91a and is connected to the test pad 62-1". The test pad 62-1" overlaps with the via section of the second connection line 92b and the first dielectric layer 91a surrounding the via section of the second connection line 92b.

The width of the test pad 62-1" is greater than the width of the second chip pad PAD2. As illustrated in FIG. 27, the width of the second chip pad PAD2 is W31. The width of the test pad 62-1" is W32. W32 is greater than W31.

The distance between the test pad 62-1" and the external connection bump 61-1" closest to the test pad 62-1" is greater than the distance between the second chip pad PAD2 and the first chip pad PAD1 closest to the second chip pad PAD2. The distance between the second chip pad PAD2 and the first chip pad PAD1 closest to the second chip pad PAD2 is d1'. The distance between the test pad 62-1" and the external connection bump 61-1" closest to the test pad 62-1" is d2'. The d2' is greater than d1'.

A second UBM pattern 71b-1" is disposed on the test pad 62-1". The second UBM pattern 71b-1" is interposed between the test pad 62-1" and the second connection line 92b, and between the test pad 62-1" and the first dielectric layer 91a. The second UBM pattern 71b-1" connects the test pad 62-1" and the second connection line 92b.

A third UBM pattern 71c-1" is disposed below the first connection line 92a. The third UBM pattern 71c-1" is interposed between the first connection line 92a and the first UBM pattern 71a-1", and between the first connection line 92a and the first dielectric layer 91a. The third UBM pattern 71c-1" connects the first UBM pattern 71a-1" and the first connection line 92a.

The third UBM pattern 71c-1" may include a barrier metal layer disposed on the first UBM pattern 71a-1" and the first dielectric layer 91a, and a seed layer disposed on the barrier metal layer. The barrier metal layer may include titanium. The barrier metal layer may be a titanium layer. The seed layer may include copper. The seed layer may be a copper layer. The first connection line 92a may be formed by a plating process using the seed layer.

A fourth UBM pattern 71d-1" is disposed below the second connection line 92b. The fourth UBM pattern 71d-1" is interposed between the second connection line 92b and the second UBM pattern 71b-1", and between the second connection line 92b and the first dielectric layer 91a. The fourth UBM pattern 71d-1" connects the second UBM pattern 71b-1" and the second connection line 92b.

The fourth UBM pattern 71d-1" may include a barrier metal layer disposed on the second UBM pattern 71b-1" and the first dielectric layer 91a, and a seed layer disposed on the barrier metal layer. The barrier metal layer may include titanium. The barrier metal layer may be a titanium layer. The seed layer may include copper. The seed layer may be a copper layer. The second connection line 92b may be formed by a plating process using a seed layer.

The second dielectric layer 91b is disposed on the first dielectric layer 91a, the first connection lines 92a, and the second connection line 92b. The second dielectric layer 91b covers the upper surface of the first dielectric layer 91a, the upper surface and side surfaces of the first connection line 92a, and the upper surface and side surfaces of the second connection line 92b.

The first bump pad 93a is disposed on the second dielectric layer 91b. The first bump pad 93a vertically penetrates the second dielectric layer 91b and is connected to the first connection line 92a.

The second bump pad 93b is disposed on the second dielectric layer 91b. The second bump pad 93b vertically penetrates the second dielectric layer 91b and is connected to the second connection line 92b. Two second bump pads 93b are commonly connected to one second connection line 92b. In FIG. 26 and FIG. 27 , the number of second bump pads 93b connected to one second connection line 92b is two, but the present disclosure is not limited thereto. In another embodiment, the number of second bump pads connected to one second connection line may be one, three, or more.

A fifth UBM pattern 71e-1" is disposed below the first bump pad 93a. The fifth UBM pattern 71e-1" is interposed between the first bump pad 93a and the first connection line 92a, and between the first bump pad 93a and the second dielectric layer 91b. The fifth UBM pattern 71e-1" connects the first bump pad 93a and the first connection line 92a.

The fifth UBM pattern 71e-1" may include a barrier metal layer disposed on the first connection line 92a and the second dielectric layer 91b, and a seed layer disposed on the barrier metal layer. The barrier metal layer may include titanium. The barrier metal layer may be a titanium layer. The seed layer may include copper. The seed layer may be a copper layer. The first bump pad 93a may be formed by a plating process using the seed layer.

A sixth UBM pattern 71f-1" is disposed below the second bump pad 93b. The sixth UBM pattern 71f-1" is interposed between the second bump pad 93b and the second connection line 92b, and between the second bump pad 93b and the second dielectric layer 91b. The sixth UBM pattern 71f-1" connects the second bump pad 93b and the second connection line 92b.

The sixth UBM pattern 71f-1" may include a barrier metal layer disposed on the second connection line 92b and the second dielectric layer 91b, and a seed layer disposed on the barrier metal layer. The barrier metal layer may include titanium. The barrier metal layer may be a titanium layer. The seed layer may include copper. The seed layer may be a copper layer. The second bump pad 93b may be formed by a plating process using a seed layer.

The first semiconductor chip 10 is mounted on the redistribution substrate 90 by the first front bump 13A and the first test bump 13C. The first front bump 13A of the first semiconductor chip 10 is placed on the first bump pad 93a of the redistribution substrate 90, and the solder layer 13Cb of the first front bump 13C is bonded to the first bump pad 93a. The first test bump 13C of the first semiconductor chip 10 is placed on the second bump pad 93b of the redistribution substrate 90, and the solder layer 13Cb of the first test bump 13C is bonded to the second bump pad 93b. The first semiconductor chip 10 is physically and electrically connected to the redistribution substrate 90 via the first front bump 13A and the first test bump 13C.

The second semiconductor chip 20 is stacked on the first semiconductor chip 10, and the third semiconductor chip 30 is stacked on the second semiconductor chip 20. The mold member 40K surrounds the first semiconductor chip 10, the second semiconductor chip 20, and the third semiconductor chip 30. The mold member 40K extends between the redistribution substrate 90 and the first semiconductor chip 10. The mold member 40K surrounds the first front bump 13A and the first test bump 13C.

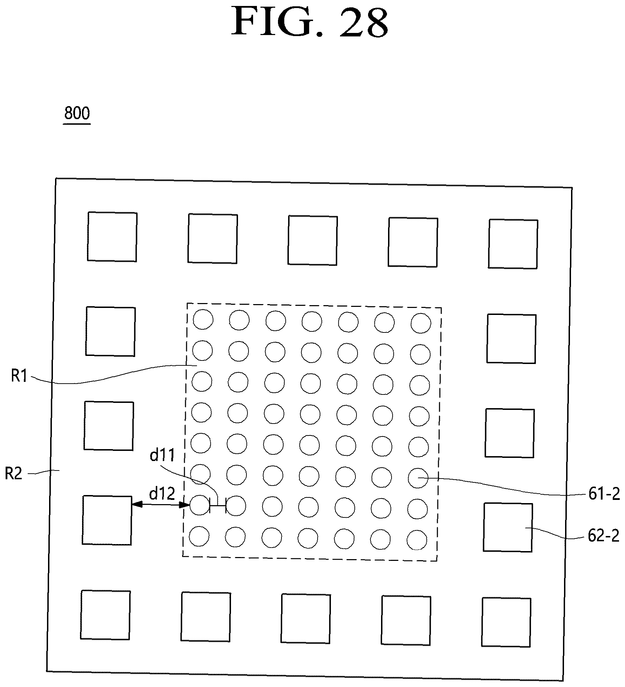

FIG. 28 is a plan view illustrating external connection bumps and test pads according to an embodiment of the present disclosure.

Referring to FIG. 28, a chip stack package 800 according to an embodiment of the present disclosure includes a first region R1 in which connection bumps 61-2 are arrayed and a second region R2 outside the first region R1.

The second region R2 may surround the first region R1. The first region R1 may be a central region of the chip stack package 800. The second region R2 may be an edge region of the chip stack package 800. The test pad 62-2 may be disposed in the second region R2. The distance between the test pad 62-2 and the external connection bump 61-2 closest to the test pad 62-2 is greater than the distance between neighboring external connection bumps 61-2. The distance between neighboring external connection bumps 61-2 is d11. The distance between the test pad 62-2 and the external connection bump 61-2 closest to the test pad 62-2 is d12. The d12 is greater than d11.

Because the test pad 62-2 is disposed in the second region R2 outside the first region R1 where the external connection bumps 61-2 are arrayed, the distance between the test pad 62-2 and the external connection bump 61-2 closest to the test pad 62-2 can be configured to be greater than the distance between neighboring external connection bumps 61-2. Accordingly, when a test pin of a test device comes into contact with the test pad 62-2 in the test mode, interference between the test pin and the external connection bump 61-2 can be suppressed or prevented.

Concepts are disclosed in conjunction with examples and embodiments as described above. Those skilled in the art will understand that various modifications, additions, and substitutions are possible without departing from the scope and technical concepts of the present disclosure. Embodiments disclosed in the present specification should be considered from an illustrative standpoint and not a restrictive standpoint. Therefore, the scope of the present disclosure is not limited to the above descriptions. All changes within the meaning and range of equivalency of the claims are included within their scope.

## Claims

1. A chip stack package comprising:
a first semiconductor chip having a first test bump on a first surface;
a second semiconductor chip stacked on a second surface of the first semiconductor chip opposite the first surface;
a second test bump bonded to the first test bump;
a mold member surrounding the first semiconductor chip, the second semiconductor chip, and the second test bump; and
a test pad disposed on the mold member and connected to the second test bump.

2. The chip stack package of claim 1, wherein first semiconductor chip includes:
a first substrate; and
a wiring structure disposed below the first substrate,
wherein the wiring structure includes a chip pad connected to the first test bump, and
wherein a planar area of the test pad is greater than a planar area of the chip pad.

3. The chip stack package of claim 2, wherein the first semiconductor chip includes a plurality of first test bumps including the first test bump,
wherein the test bumps of the plurality of first test bumps are commonly connected to the chip pad,
wherein the test bumps of a plurality of second test bumps including the second test bump are respectively connected to the plurality of first test bumps, and
wherein the test bumps of the plurality of second test bumps are commonly connected to the test pad.

4. The chip stack package of claim 1, further comprising:
a front bump disposed on the first surface of the first semiconductor chip;
a carrier bump bonded to the front bump; and
an external connection bump positioned on the mold member and connected to the carrier bump,
wherein the mold member surrounds the front bump and the carrier bump.

5. The chip stack package of claim 4, wherein a size of the first test bump is the same as a size of the front bump.

6. The chip stack package of claim 4, wherein the test pad is arranged in a second region outside a first region where the connection bumps of a plurality of external connection bumps including the external connection bump are arrayed.

7. The chip stack package of claim 6, wherein a distance between an external connection bump closest to the test pad among the plurality of external connection bumps and the test pad is greater than a distance between neighboring external connection bumps.

8. The chip stack package of claim 4, wherein a planar area of the test pad is greater than a planar area of the external connection bump.

9. The chip stack package of claim 1, wherein the first test bump includes:
a first nickel layer; and
a solder layer below the first nickel layer,
wherein the solder layer is in contact with the second test bump.

10. The chip stack package of claim 9, wherein the second test bump includes a second nickel layer, and
wherein the solder layer is in contact with the second nickel layer.

11. The chip stack package of claim 1, wherein the first test bump includes:
a first copper layer;
a first nickel layer below the first copper layer; and
a solder layer below the first nickel layer,
wherein the solder layer is in contact with the second test bump.

12. The chip stack package of claim 11, wherein a thickness of the first copper layer is greater than a thickness of the first nickel layer.

13. The chip stack package of claim 11, wherein the second test bump includes:
a second copper layer; and
a second nickel layer on the second copper layer,
wherein the solder layer is in contact with the first nickel layer and the second nickel layer.

14. The chip stack package of claim 13, wherein a thickness of the second copper layer is greater than a thickness of the second nickel layer.

15. The chip stack package of claim 1, wherein the first test bump includes:
a first copper layer;
a first nickel layer below the first copper layer;
a second copper layer below the first nickel layer; and
a solder layer below the second copper layer;
wherein the solder layer is in contact with the second test bump.

16. The chip stack package of claim 15, wherein a thickness of the first copper layer is greater than a thickness of the first nickel layer.

17. The chip stack package of claim 15, wherein a thickness of the second copper layer is less than a thickness of the first copper layer.

18. The chip stack package of claim 15, wherein the second test bump includes:
a third copper layer;
a second nickel layer on the third copper layer; and
a fourth copper layer on the second nickel layer,
wherein the solder layer is in contact with the second copper layer and the fourth copper layer.

19. A chip stack package comprising:
a first semiconductor chip having a test bump on a first surface;
a second semiconductor chip stacked on a second surface of the first semiconductor chip opposite the first surface;
a mold member surrounding the first semiconductor chip and the second semiconductor chip; and
a test pad disposed below the mold member and connected to the test bump.

20. A chip stack package comprising:
a first semiconductor chip having a first test bump on a first surface;
a second semiconductor chip stacked on a second surface of the first semiconductor chip opposite the first surface;
a second test bump bonded to the first test bump;
a mold member surrounding the first semiconductor chip, the second semiconductor chip, and the second test bump;
a redistribution layer disposed on the mold member and the second test bump; and
a test pad disposed on the redistribution layer.
